(19) **Europäisches Patentamt**
**European Patent Office**
**Office européen des brevets**

(11) **EP 2 434 413 B1**

(12) **EUROPEAN PATENT SPECIFICATION**

(45) Date of publication and mention
of the grant of the patent:
**26.03.2014 Bulletin 2014/13**

(51) Int Cl.:
*G06F 17/30* (2006.01)    *H03M 13/37* (2006.01)

(21) Application number: **10010280.5**

(22) Date of filing: **23.09.2010**

(54) **Method and distributed computing system for synchronizing data-sets stored on different communication devices**

Verfahren und verteiltes Datenverarbeitungssystem zur Synchronisierung von Datensätzen, die auf verschiedenen Kommunikationsvorrichtungen gespeichert sind

Procédé et système informatique distribué pour synchroniser les ensembles de données stockés sur des dispositifs de communication différents

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(43) Date of publication of application:
**28.03.2012 Bulletin 2012/13**

(73) Proprietor: **Deutsche Telekom AG**
**53113 Bonn (DE)**

(72) Inventor: **Sachin Kumar Agarwal**
**10409 Berlin (DE)**

(74) Representative: **Blumbach Zinngrebe**
**Patentanwälte**
**Alexandrastrasse 5**
**65187 Wiesbaden (DE)**

(56) References cited:
- **AGARWAL S ET AL: "Near optimal update-broadcast of data sets", PROCEEDINGS - IEEE INTERNATIONAL CONFERENCE ON MOBILE DATA MANAGEMPROC., IEEE 8TH INTERNATIONAL CONFERENCE ON MOBILE DATA MANAGEMENT, MDM 2007, 27 January 2007 (2007-01-27), - 1 February 2007 (2007-02-01), pages 356-360, XP002646583, DOI: DOI: 10.1109/MDM.2007.75**
- **STAROBINSKI D ET AL: "EFFICIENT PDA SYNCHRONIZATION", IEEE TRANSACTIONS ON MOBILE COMPUTING, IEEE SERVICE CENTER, LOS ALAMITOS, CA, US, vol. 2, no. 1, 1 January 2003 (2003-01-01) , pages 40-51, XP001171684, ISSN: 1536-1233, DOI: DOI:10.1109/TMC. 2003.1195150**
- **S. Agarwal: "Efficient reconciliation of unstructured and structured data over networks", Dissertation, Boston University , February 2006 (2006-02), pages 1-126, XP002646584, Retrieved from the Internet: URL: http://gradworks.umi.com/31/86/3186484 .html [retrieved on 2011-06-27]**
- **AGARWAL S ET AL: "Adaptive rateless coding under partial information", PROC., IEEE INFORMATION THEORY AND APPLICATIONS WORKSHOP, 2008, 27 January 2008 (2008-01-27), - 1 February 2008 (2008-02-01), pages 5-11, XP031307624, ISBN: 978-1-4244-2670-6**

**Description**

**Field of the Invention**

The present invention is directed to a method and a distributed computing system for synchronizing data-sets stored on different communication devices.

**Background of the Invention**

A distributed computing system comprises a plurality of geographically distributed computers such as PDAs, notebooks or mobile phones that are connected intermittently via a digital transmission technology. Such distributed computing systems share common data among the geographically distributed computers and the data may be modified independently on the computers during the usage of the data-set by applications, but there may be a large overlap between the data-set elements of the data-sets. Therefore, it is necessary to synchronize this data across the different computers from time to time in order to return the distributed computing system to a synchronized state. Frequent synchronization is a resource intensive process in terms of communication and computation and is therefore limited to periodic invocations. The time period between data synchronizations is an application dependent parameter and may vary from real time (fraction of a second) to lazy replication (every few months). In some instances, the time period between data synchronizations is left open ended (no fixed periodicity) and data synchronization is invoked manually as desired by the distributed system's users. It is important to have efficient data synchronization systems in order to minimize the costs of repeated data synchronization in distributed systems. Efficient data synchronization can also encourage a greater degree of synchronization between distributed computers and thereby increase the effectiveness of a distributed computing system.

Data synchronization is a process of synchronizing, for example, two similar data-sets stored on two different computers connected via a communication link. A data-set is an unordered collection of digital information elements that can be stored on a digital communication device, also called herein a host. Such a communication device comprises computational, data storage, and digital communication facilities. The end result of the data synchronization procedure should be identical copies of the data-sets on both the computers.

S. Agarwal et al: "Near optimal update-broadcast of data sets", PROCEEDINGS, IEEE 8TH INTERNATIONAL CONFERENCE ON MOBILE DATA MANAGEMENT, 27 January 2007 - 1 February 2007, pages 356-360, XP002646583, is a conference contribution concerned with broadcasting incremental updates from a data source to multiple terminals that contain outdated (and possibly different) copies of the data. Herein, a set reconciliation algorithm for rateless encoding has been used. A two-channel protocol is used in which new source items are determined over one channel and are utilized for rateless decoding on a secondary channel.

D. Starobinski et al: "Efficient PDA Synchronization", IEEE TRANSACTIONS ON MOBILE COMPUTING, vol. 2, no. 1, 1 January 2003, pages 40-51, XP001171684, is a scientific publication describing a synchronization scheme for heterogeneous networks of many machines such as PCs and PDAs. Herein, data is translated into a certain type of polynomial known as the characteristic polynomial. When synchronizing, the PDA sends sampled values of its characteristic polynomial to the PC.

S. Agarwal: "Efficient reconciliation of unstructured and structured data over networks", Boston University, February 2006, XP002646584, is a dissertational work concerned with a data synchronization scheme whose salient property is that its communication complexity depends on the number of differences between the PDA and PC. The approach involves transforming a string into a multi-set of substrings that are reconciled efficiently using the set reconciliation algorithms, and then put back together on a remote host using recent graph-theoretic techniques.

It is an object of the present invention to make available a new method and a distributed computing system for synchronizing data-sets stored on different communication devices which lead to a reduced data exchange between two communication devices during the data synchronization procedure.

It is a further aspect of the present invention to provide data-protection guarantees when synchronizing data-sets are transmitted over loss/error-prone channels, i.e. communication links.

Therefore, the computational burden of the procedure can be reduced so that the synchronization procedure can complete in a small finite amount of time. Lower computational complexity during the synchronization process also conserves energy which is a limited resource on battery-operated communication devices such as mobile phones. Moreover, the data synchronization process will succeed even when the communication channel between the two communication devices loses some of the communication data packets. This measurement of the invention makes the data synchronization process more robust and fault-tolerant as compared to simply copying the data-sets from one communication device to the other.

It is a further aspect of the present invention to provide a measurement for reducing the unfavorable computational complexity at the decoding stage of a communication device.

## Summary of the Invention

It is a core aspect of the present invention to use a forward error correction code for both data synchronization as well as an error-resistant data transmission during the data synchronization process. In particular, a random linear code technology which is traditionally used for error detection and correction is utilized.

In order to synchronize large data sets by using random linear codes a set partitioning is performed on the large data sets. Therefore, a distributed computing system is made scalable by dividing the data synchronization issue into many smaller synchronization tasks. This results in significantly lower computational complexity at the decoding communication device, allowing the data synchronization to complete much faster (lesser computation time of the system) and also save communication between the two synchronizing communication devices.

The technical problem outlined above is solved by the method steps of claim 1.

Therefore, a method for synchronizing data-sets stored on different communication devices which are connected via communication links has been made available. The method comprises the following steps:

1a) Storing a first data-set on a first communication device, said first data-set including a number of m elements;
1b) Storing a second data-set on a second communication device, said second data-set including a number of n elements, where n can be equal to, less or greater than m;
1c) Encoding, at the first communication device, the first data-set by using a random linear code to obtain a number of k encoded elements, wherein k is a tunable parameter;
1d) Determining, at the second communication device, the total number of elements, which are different between said first and second data-set, on the basis of a message received from the first communication device;
1e) Determining, at the second communication device, whether the total number of different elements is less than or equal to the parameter k;
1f) If yes, transmitting the k encoded elements from the first communication device to the second communication device; and
1g) Decoding, at the second communication device, at least some of the received encoded elements by using a random linear decoder in order to obtain all elements of the first data-set, which are not contained in the second data-set.

It should be noted that parameter k may be less than m.

However, random linear codes are very impractical and require huge computational performance when the data-sets to be synchronized and the number of differences between the data-sets are large. In order to reduce the computational complexity of random linear codes a novel encoding and decoding procedure are provided which are based upon a divide-and solve approach. This approach allows for quick, efficient, and power saving computational processing at the second communication device operating as a decoding device. The divide-and solve approach achieves these properties inter alia by using limited communication between the first and second communication device.

Therefore, the method further comprises the followings steps:

2a) Performing a set partitioning on the first data-set in order to obtain a plurality of first data-subsets;
2b) Performing a set partitioning on the second data-set in order to obtain a plurality of second data-subsets, wherein each of the first data-subsets corresponds to a separate one of the second data-subsets;
2c) Encoding, at the first communication device, each first data-subset by using a random linear code in order to obtain a number of k encoded elements;
2d) If the number of different elements determined in step 1d) is greater than k, then selecting, at the second communication device, a second data-subsets of the second data-set and selecting, at the first communication device, the corresponding first data-subset in response to a message received from the second communication device;
2e) Determining, at the second communication device, the number of elements, which are different between the selected second data-subset and the corresponding first data-subset on the basis of a message received from the first communication device;
2f) Determining, at the second communication device, whether the number of different elements is less than or equal to the parameter k;
2g) If yes, then transmitting the k encoded elements of the first data-subset from the first communication device to the second communication device; and
2h) Decoding, at the second communication device, at least some of the received encoded elements by using a random linear decoder in order to obtain the elements of the selected first data-subset, which are not contained in the selected second data-subset of the second data-set;
2i) Repeating steps 2d) to 2h) until all elements of the first data-set, which were initially not contained in the second data-set, have been decoded at the second communication device.

It should be noted that the order of execution of the method steps as outlined above is not fixed and may be reorder as appropriate.

The computational complexity can be optimized when the set partitioning steps result in a hierarchical, multilevel tree which comprises the plurality of first data-subsets and in a similar hierarchical, multilevel tree which comprises the plurality of second data-subsets.

In a preferred embodiment, the random linear code encoding procedure executes step 1c) which comprises the further step of creating a k x m-Beta random number matrix, wherein said m elements of the first data-set are represented by an m-element column vector ($V_A$) and said k encoded elements are represented by a k-element column vector ($V_Y$), which is computed by performing the matrix multiplication of the Beta random number matrix and the m-element column vector; wherein prior to performing step 1f) each of the k encoded elements is encapsulated along with the entries of the respective row of the Beta random number matrix into a separate packet to be transmitted. In the preferred embodiment, the random linear code decoding procedure executes step 1g) which comprises the step of computing the inverse of said received Beta random number matrix, wherein the m-element column vector is computed by performing the matrix multiplication of the inverse of said Beta random number matrix and the k-element column vector.

If a set partitioning is performed step 2c) preferably comprises the further step of creating with respect to each first data-subset a k x $l_i$-Beta random number matrix, where $l_i$ corresponds to the number of elements of the ith first data-subset and $l_i$ is less than m, wherein said $l_i$ elements of the ith first data-subset are represented by an $l_i$-element column vector and said k encoded elements are represented by a k-element column vector, which is computed by performing the matrix multiplication of the Beta random number matrix and the $l_i$-element column vector, wherein prior to performing step 2g) each of the k encoded elements is encapsulated along with the entries of the respective row of the Beta random number matrix into a separate packet to be transmitted. Furthermore, step 2h) comprises the step of computing the inverse of the received k x $l_i$-Beta random number matrix, wherein the $l_i$-element column vector is computed by performing the matrix multiplication of the inverse of said Beta random number matrix and the k-element column vector.

In order to reduce the computational complexity at the decoding stage it is advantageously that prior to performing the decoding step 1g) the common elements between the first data-set and the second data-set are determined and that only the received encoded elements which are not included in the second data-set are decoded, and/or that prior to performing the decoding step 2h) the common elements between the selected second data-subset and the corresponding first data-subset are determined and that only the received encoded elements which are not included in the selected data-subset of the second data-set are decoded.

In order to determining, at the second communication device, the total number of elements, which are different between said first and second data-set step 2d) comprises advantageously the following steps:

transmitting a request from the second communication device to the first communication device for sending a message concerning all elements included in the first data-set;
transmitting the message in a single packet to the second communication device, and wherein
step 2e) advantageously comprises the following steps: transmitting a request from the second communication device to the first communication device for sending a message concerning all elements included in the selected first data-subset;
transmitting the respective message in a single packet to the second communication device.

In order to reduce the amount of data to be transmitted the message comprises the hashes of each element included in the first data-set and/or the hashes of each element of the selected first data-subset. Step 1d) then comprises the further steps of:

generating, at the second communication device, the hash of each element included in the second data-set;
comparing the hashes of each element included in the first data-set received from the first communication device to the hashes of the elements of the second data-set in order to determine the total number of elements of the first data-set which are not included in the second data-set; and wherein step 2e) comprises the further steps of: generating, at the second communication device, the hash of each element included in the selected second data-subset;
comparing the hashes of each element of the selected first data-subset received from the first communication device with the hashes of the elements of the selected second data-subset in order to determine the number of elements of the selected first data-subset which are not included in the selected second data-subset.

In a preferred embodiment 2g) comprises the step of requesting the first communication device for sending the k encoded elements.

In order to optimize the computational complexity of the encoding and decoding process the method may comprise the following steps of:

determining, at the second communication device, whether the number of elements of the second data-set or the number of elements of a selected second data-sub-set is less than or equal to the parameter k;

if yes, then requesting the first communication device for transmitting all elements of the first data-set or for transmitting all elements of the selected first data-subset, which corresponds to the selected second data-subset, to the second communication device.

The above mentioned technical problem is also solved by a distributed computing system for synchronizing data-sets stored on different communication devices which are connected via communication links. That system comprises a first communication device which comprises the following features:

- first storage means for storing a first data-set, said first data-set including a number of m elements,
- an encoder for encoding the first data-set by using a random linear code to obtain a number of k encoded elements, wherein k is a tunable parameter,
- a transmitter for transmitting the k encoded elements to the second communication device in response to a request. The system further comprises a second communication device connected via a communication link with the first communication device. The second communication device comprises the following features:

- first storing means for storing a second data-set, said second data-set including a number of n elements;
- means for determining the total number of elements, which are different between said first and second data-set, on the basis of a message received from the first communication device and for determining, whether the total number of different elements is less than or equal to the parameter k,
- a decoder for decoding at least some of the received encoded elements by using a random linear decoder in order to obtain all elements of the first data-set, which are not contained in the second data-set.

In a preferred embodiment, the first communication device comprises second storage means for storing the encoded elements.

However, random linear codes are very impractical and require huge computational performance when the data-sets to be synchronized and the number of differences between the data-sets are large. In order to reduce the computational complexity of random linear codes a novel encoding and decoding procedure are provided which are based upon a divide-and solve approach.

Therefore, the first communication device further comprises preferably means for performing a set partitioning on the first data-set in order to obtain a plurality of first data-subsets, means for selecting a first data-subset in response to a message received from the second communication device, wherein the encoder is adapted to encode each first data-subset by using a random linear code in order to obtain a number of k encoded elements. In addition, the second communication device preferably comprises means for performing a set partitioning on the second data-set in order to obtain a plurality of second data-subsets, wherein each first data-subset corresponds to a separate second data-subset of the second data-set, and means for selecting at least one second data-subset according to a predetermined rule.

In a preferred embodiment, the encoder is adapted to use a k x m-Beta random number matrix to encode the first data-set, wherein the first communication device comprises means for encapsulating each of the k encoded elements along with the entries of the respective row of the Beta random number matrix into a separate packet. Moreover, the decoder is adapted to compute the inverse of the received Beta random number matrix.

In order to synchronize corresponding data-subsets the encoder is adapted to use, for each first data-subset to be encoded, a k x $l_i$-Beta random number matrix, where $l_i$ corresponds to the number of elements of the ith first data-subset and $l_i$ is less than m, wherein the first communication device comprises means for encapsulating each of the k encoded elements of a respective first data-subset along with the entries of the respective row of the k x $l_i$-Beta random number matrix into a separate packet. The decoder is adapted to compute the inverse of the received k x $l_i$-Beta random number matrix.

## Brief Description of the Drawings

The invention together with its objects and the advantages thereof may be best understood by references to the following description taken in conjunction with the accompanying drawings in which:

Fig. 1   shows a preferred embodiment of a distributed computing system according to the invention,
Fig. 2   shows a number of k encoded packets,

Fig. 3    shows two preferred tree data structures for dataset $S_A$ and data-set $S_B$, respectively,

Fig. 4    shows a diagram, wherein the number of transmissions is depicted as a function of the size of the data-set, and

Fig. 5    shows a diagram, wherein the number of transmissions is depicted as a function of the difference $S_A - S_B$.

**Detailed Description of the Invention**

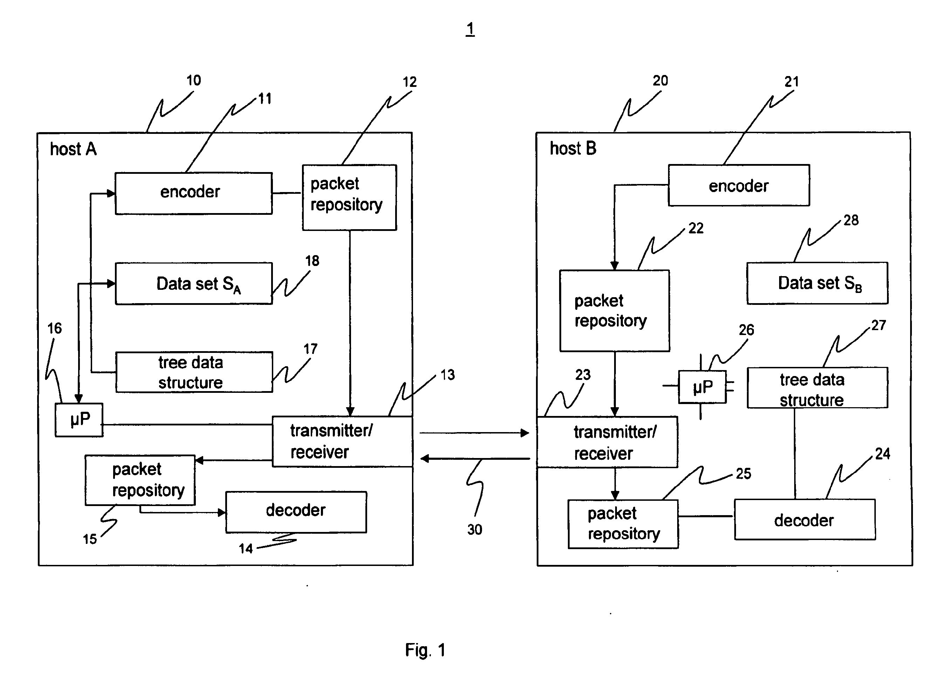

Fig. 1 illustrates a distributed computing system 1 in terms of an example. System 1 comprises at least two communication devices 10 and 20 which may be mobile phones, PDAs, notebooks or other mobile or stationary computing devices. In this embodiment communication device 10 is a computer and communication device 20 is represented by a mobile phone. The communication devices 1 and 20 are connected via a wireless communication medium 30 and communicate with each other by using for example the Bluetooth Standard or other wireless communication standards. Computer 10 may comprise a memory 18 for storing the elements of a data-set $S_A$, a memory 17 for storing a hierarchical tree-based data-structure of data-set $S_A$, an encoder 11 adapted to create a number of encoded packets used for data synchronization on the mobile phone, a memory 12, named packet repository, for storing the encoded packets, a decoder 14 for decoding encoded packet received from mobile phone 20 to perform a data synchronization procedure, a packet repository 15 for storing encoded packets received from the mobile phone 20, a transmitter/receiver stage 13 to transmit messages and encoded packets to and receive messages and encoded packets from the mobile phone 20 and a microprocessor 16 which monitors and controls the components of computer 10. All components can be connected to each other.

In a similar manner mobile phone 20 may comprise a memory 28 for storing the elements of a data-set $S_B$, a memory 27 for storing a hierarchical tree-based data-structure of data-set $S_B$, an encoder 21 adapted to create a number of encoded packets used for data synchronization on the computer 10, a memory 22, named packet repository, for storing the encoded packets, a decoder 14 for decoding encoded packet received from mobile phone 20 to perform a data synchronization procedure, a packet repository 25 for storing encoded packets received from the computer 10, a transmitter/receiver stage 23 to transmit messages and encoded packets to and receive messages and encoded packets from the computer 10 and a microprocessor 26 which monitors and controls the components of the mobile phone. All components can be connected to each other.

Data synchronization between the communication devices 10 and 20 can be carried out in a one-way or two way data synchronization procedure. In the one-way data synchronization process, for example from computer 10 to the mobile phone 20, a data-set $S_A$ stored on memory 18 of the computer 10 is transferred to the mobile phone 20 and used to synchronize a data-set $S_B$ stored on memory 28. In a two-way data synchronization process the computer 10 and the mobile phone 20 would seek to find the union of their data-sets.

In this embodiment, a one-way data synchronization process from computer 10 to mobile phone 20 is described. Therefore, computer 10 can be referred to an encoding device and mobile phone 20 can be referred to a decoding device, although both communication device 10 and communication device 20 are adapted to perform encoding as well as decoding procedures. Two-way data synchronization would be merely a straight forward extension of the one-way synchronization being applied once in each direction, i.e. from computer 10 to mobile phone 20 and vice versa.

In the data synchronization setup, the two communication devices 10 and 20 are assumed to have no prior information on the existence of any particular scenarios outlined above. The system 1 described below is capable of performing a sequence of efficient and scalable computation and communication steps in order to synchronize data-set $S_A$ stored on the computer 10 and data-set $S_B$ stored on the mobile phone 20. In particular, the distributed computing system 1 is adapted to perform a Random Linear Encoding and Decoding procedure for both data synchronization and error-correction. Therefore, a general overview of Random Linear Codes and Linear Random Encoding and Decoding procedures is given now as far as it is important to the invention.

**1. Random Linear Codes**

Random Linear Codes are a class of known error-correcting rateless codes used for data transmission over lossy communication channels and for reliable data storage. They are used to encode information into packets before transmitting the information or storing it, and the packets are subsequently decoded by a receiver of the information. The encoding offers protection against data transmission losses by introducing redundant information so that the receiver can reconstruct the original information from the received encoded packets.

In the following two sections we introduce some notation and describe the encoding process, and the decoding process of random linear codes, based on standard descriptions of Random Linear Coding in the coding theory literature.

**2. Encoding Process based on Random Linear Codes**

The traditional encoding process is now explained. It is assumed that computer 1 is able to execute such an encoding procedure.

Given are an m-element data-set $S_A = \{x_1, x_2,..., x_m\}$, which is stored on the memory 18 of the computer 10, and a tunable parameter k specifying the number of encoded elements to transmit to the mobile phone 20. Data-set $S_A$ can be represented by an m-element column Vector $V_A$ as follows:

$$V_A = \begin{bmatrix} x_1 \\ x_2 \\ \vdots \\ x_m \end{bmatrix}$$

Encoder 11 of computer 10 is adapted to produce k encoded elements which can be represented as a column vector $V_Y = \{y_1, y_2, ..., y_k\}$, with k entries, where k is generally greater than m. The encoder may be also called a Random Linear Code encoder. The encoding procedure requires a Beta matrix $\beta$ that is represented as a k x m matrix as shown below:

$$\beta = \begin{bmatrix} \beta_{11} & \beta_{12} & \cdots & \beta_{1m} \\ \beta_{21} & \ddots & & \vdots \\ \vdots & \vdots & \ddots & \vdots \\ \beta_{k1} & \cdots & \cdots & \beta_{km} \end{bmatrix}$$

Each element of the *k* x m Beta random matrix is chosen to be either 0 or 1 with probability 0.5. A suitable random number generator can be employed to generate each of the *k* x m elements of this Beta random matrix. In this manner, approximately half of the elements of the Beta random matrix will be 1 and approximately half of the elements will be 0.

The column vector $V_Y$ is computed by the encoder 11 as follows:

$$\texttt{Beta} \; * \; \texttt{V}_\texttt{A} \; = \; \texttt{V}_\texttt{Y},$$

where * denotes a matrix multiplication.

In particular, the encoded packet vector $V_Y$ is computed as follows:

$$V_Y = \begin{bmatrix} y_1 \\ y_2 \\ \vdots \\ y_k \end{bmatrix} = \beta \times V_A = \begin{bmatrix} \beta_{11} & \beta_{12} & \cdots & \beta_{1m} \\ \beta_{21} & \ddots & & \vdots \\ \vdots & \vdots & \ddots & \vdots \\ \beta_{k1} & \cdots & \cdots & \beta_{km} \end{bmatrix} \times \begin{bmatrix} x_1 \\ x_2 \\ \vdots \\ x_m \end{bmatrix}$$

Now the encoding procedure on computer 10 is completed and each row of the Beta matrix together with the respective element of vector $V_Y$ can be stored on memory 12.

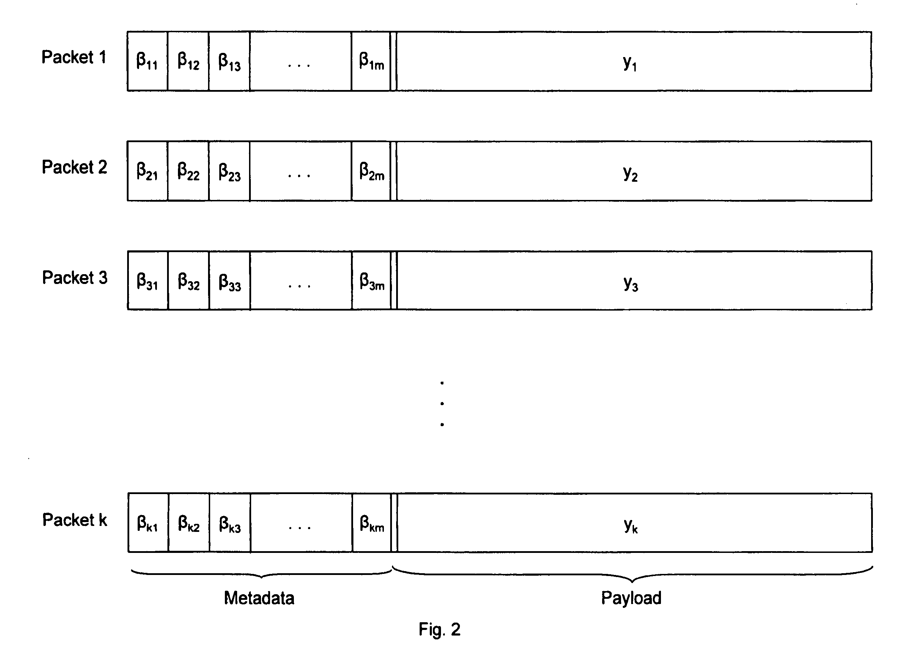

Once the encoding process has been finished the k encoded entries or elements of the encoded column vector $V_Y$ are transmitted via transmitter/receiver 13 to the transmitter/receiver stage 23 of the mobile phone 20 and decoded there by decoder 24. Each element of the vector $V_Y$ along with the corresponding row of the Beta random matrix is encapsulated into a separate transmission packet and each packet is transmitted separately over the communication channel 30. An exemplary packet structure is shown in Fig. 2. It comprises a metadata field for carrying the respective row of the Beta matrix and a payload field for carrying the respective entry of the vector $V_Y$. The step of packetizing can be executed by the encoder 11 under control of microprocessor 16. The microprocessor 16 addresses the memory 12 to direct the respective Beta matrix row and the corresponding vector element to the encoder 11. Some of these packets may be lost during transmission. However, the random linear code decoder 24 of the mobile phone 20 can recover the entire data-set $S_A$ as soon as at least m packets are received at the decoder 24.

### 3. Random Linear Code Decoding System

It is the task of the decoder 24 to decode the encoded column vector $V_Y$ to retrieve the original m-element data-set $S_A$, represented as the column vector $V_A$ with m entries. However, the decoder 24 requires at least m rows of the encoding Beta matrix $\beta$ that are contained in the received packets. With other words, at least m of the k transmitted packets must be received correctly at the mobile phone 20.

At the decoder 24, the elements of $S_A$ are then computed as follows:

$$V_A = (Beta)^{-1} * V_Y,$$

where $(Beta)^{-1}$ is the inverse of the Beta matrix used by the encoder 11 and * denotes matrix multiplication. Note that this process is isomorphic to solve m linear equations for m unknown variables, i.e. the m elements of data-set $S_A$. The number of m linear equations exactly corresponds to the number of elements of data-set $S_A$. Therefore, the decoding process will complete successfully only if the row rank of the Beta matrix is at least m, i.e. the number of unknown variables. Row rank is defined as the number of linearly independent rows of the Beta matrix. One of the inefficiencies of the random linear coding approach outlined above is that because computer 10 has no prior information about the difference $S_A$ - $S_B$, k has to be greater than or equal to the size m of data set $S_A$ to allow for successful synchronization for the case that there are no common elements between the data-sets $S_A$ and $S_B$. The difference $S_A$ - $S_B$ is defined as the number of the elements of data-set $S_A$ which are not included in data-set $S_B$. Therefore, the number of encoded packets transmitted will be in the order of the size m of the data-set $S_A$, making this approach highly unscalable when the difference $S_A$ - $S_B$ is much smaller than the size m of data-set $S_A$.

After all, if $k \geq m$, then decoder 24 can reconstruct the column vector $V_A$ as follows:

1. First, if $k > m$, then any $k\text{-}m$ rows of the Beta matrix and the corresponding encoded elements can be discarded from $V_Y$ because in order to solve for m unknowns $(x_1, x_2, ..., X_m)$ only m linear equations are needed. The resulting Beta matrix and $V_Y$ is used in the steps below.
2. Compute the inverse $\beta^{-1}$ of the Beta matrix. Note that $\beta^{-1}$ has the dimension of m x $k$.
3. Then the vector $V_A$ can be reconstructed as follows

$$V_A = \beta^{-1} \times V_Y = \begin{bmatrix} \beta'_{11} & \beta'_{12} & \cdots & \beta'_{1k} \\ \beta'_{21} & \ddots & & \vdots \\ \vdots & \vdots & \ddots & \vdots \\ \beta'_{k1} & \cdots & \cdots & \beta'_{mk} \end{bmatrix} \times \begin{bmatrix} y_1 \\ y_2 \\ \vdots \\ y_k \end{bmatrix} = \begin{bmatrix} x_1 \\ x_2 \\ \vdots \\ x_m \end{bmatrix}$$

For a better understanding of the decoding procees as described above, a numerical example is given with m=3 and k=4.

The data-set $S_A$ stored on memory 18 of computer 10 comprises the elements 2, 3 and 4 and is defined by $S_A$ = {2, 3, 4} and therefore,

$$V_A = \begin{bmatrix} 2 \\ 3 \\ 4 \end{bmatrix}.$$

A k x m-Beta matrix of dimension 4 x 3 is computed by a random number generator as follows:

$$\beta = \begin{bmatrix} 0 & 0 & 1 \\ 0 & 1 & 0 \\ 1 & 0 & 0 \\ 1 & 1 & 1 \end{bmatrix}$$

Then, the encoder 11 on the computer 11 can compute vector $V_Y$ as follows:

$$V_Y = \beta \times V_A = \begin{bmatrix} 0 & 0 & 1 \\ 0 & 1 & 0 \\ 1 & 0 & 0 \\ 1 & 1 & 1 \end{bmatrix} \times \begin{bmatrix} 2 \\ 3 \\ 4 \end{bmatrix} = \begin{bmatrix} 4 \\ 3 \\ 2 \\ 9 \end{bmatrix}$$

It is assumed that the four rows of the Beta matrix and the four elements {4, 3, 2, 9} are stored in memory 12.
Next, four encoded packets are created at the computer 10 as follows:

Packet 1: [0 0 1 || 4]
Packet 2: [0 1 0 || 3]
Packet 3: [0 0 1 || 2]
Packet 4: [1 1 1 || 9].

These packets can be stored also in memory 12.
Next, each packet 1 to 4 is transmitted from the computer 10 over the communication channel 30 to mobile phone 20. These packets can be stored in packet repository 25 of the mobile phone 20 which is connected to the decoder 24. At the mobile phone 20, the following cases may be encountered:

i. No packet lost during transmission

All 4 packets are received at the mobile phone 20.
In this case, mobile phone 20 can arbitrarily discard any one of the received packets and use the remaining three rows of the Beta matrix and the respective element of the column vector $V_Y$ transmitted in the respective packets to decode vector $V_A$.
For example, suppose Packet 2 is discarded by mobile phone 20. Then

$$\beta = \begin{bmatrix} 0 & 0 & 1 \\ 1 & 0 & 0 \\ 1 & 1 & 1 \end{bmatrix}, V_Y = \begin{bmatrix} 4 \\ 2 \\ 9 \end{bmatrix}$$

Now, the inverse $\beta^{-1}$ of Beta matrix is computed as

$$\beta^{-1} = \begin{bmatrix} 0 & 1 & 0 \\ -1 & -1 & 1 \\ 1 & 0 & 0 \end{bmatrix}$$

Finally, decoder 24 computes $V_A$ as follows:

$$V_A = \begin{bmatrix} 0 & 1 & 0 \\ -1 & -1 & 1 \\ 1 & 0 & 0 \end{bmatrix} \times \begin{bmatrix} 4 \\ 2 \\ 9 \end{bmatrix} = \begin{bmatrix} 2 \\ 3 \\ 4 \end{bmatrix}$$

Therefore, decoder 24 has been successful in decoding the elements 2, 3 and 4 of data-set $S_A$.

ii. One packet lost

In case, that only three packets are received at mobile phone 20, a decoding process similar to the one described in section i) can be performed. However, no packet can be discarded at the mobile phone 20 because the content of at least three encoded packets is required to decode the three unknown elements of data-set $S_A$ at the decoder 24.

iii. More than two packets lost

In case, that less than 3 packets arrive at the mobile phone 20, it is mathematically impossible to decode $V_A$ at the decoder 24 because the number of 3 unknown elements of $V_A$ exceeds the maximum possible rank of the Beta matrix.

The computational complexity of the decoding process at decoder 24 is primarily due to the Gaussian method for finding the inverse of the Beta matrix received at the mobile phone 20. This has been shown to require $(k^3)$ mathematical operations, making it infeasible to implement this method for a very large parameter k. Therefore, large data-sets cannot be synchronized practically using the method of random linear coding outlined above. How to solve this problem is described in detail later.

Now, the function and operation of the distributed computing system 1 is illustrated in detail.

The distributed computing system 1 is adapted to efficiently reconstruct the data-set $S_A$ of computer 10 on the mobile phone 20 taking advantage of a bi-directional communication.

System 1 uses the error correction technique, which is utilized for data error correction, also for the purpose of data synchronization. The error correction technique used is based on the random linear code technique as described above. However, several modifications and further features have been introduced, which are examplary presented below.

**4. Basic Data Synchronisation**

It is assumed that a data-set $S_B$ having a set of n data elements $\{X_1,..., x_n\}$ is stored on memory 28, that data-set $S_A$ having a set of m data elements $\{x_1,.., x_m\}$ is stored on memory 18 and that parameter k is set to a predetermined value. None, some, or all elements of data set $S_B$ may be identical to those in data set $S_A$. In case some elements are identical between data sets $S_A$ and $S_B$, the decoder 24 is adapted to detect the identical elements and only performs data synchronization on the different data elements. This results in reduced communication from computer 10 to mobile phone 20. In particular, those elements of data-set $S_A$ that are identical to the elements in data-set $S_B$ need not to be decoded by decoder 24.

First, the mobile phone 10 as the decoding device checks if its own data-set set $S_B$ has less than or equal to k elements, where k is the tunable parameter.

If this is the case then the mobile phone 20 may simply send a request via the communication channel 30 to the computer 10 for transmitting all elements of data-set $S_A$ because this is more efficient than encoding the elements of data-set $S_A$ into k packets, transmitting these k encoded packets to the mobile phone 20 and decoding the received packets by the decoder 24. After receiving the data-set $S_A$ from computer 10 mobile phone 20 simply needs to determine the difference $S_A-S_B$ to complete the data synchronization procedure.

On the other hand, if the mobile phone 20 determines that data-set $S_B$ contains more than k elements it sends a respective message to the computer 10. In response to that message computer 10 transmits a message to the mobile phone 20. The message includes an information on all m elements of data-set $S_A$. In order to reduce the amount of data to be transmitted the message can include the hashes of each element of data set $S_A$. The hashes are computed using any standard hash function h. A hash function is any well-defined procedure or mathematical function which converts a data element of the data-set into a single integer, wherein the size of the hash function is much smaller than the size of the data element. Therefore, the hashes of each element are represented by the following function:

Hash of $x_1 = h(x_1)$
Hash of $x_2 = h(x_2)$
Hash of $x_m = h(x_m)$

All hashes $[h(x_1), h(x_2),..., h(x_m)]$ can be sent in a single hash packet from computer 10 to mobile phone 20.

Mobile phone 20 also computes the hashes of all elements of data-set $S_B$ and compares these hashes to the hashes received in the hash packet. Mobile phone 20 is adapted to determine the common elements between the data sets $S_A$ and $S_B$. These common elements need not to be decoded by the decoder 24, since they are already available in the data-set $S_B$. In case that each hash transmitted in the hash packet corresponds to a hash of an element of data-set $S_B$, all m elements of data-set $S_A$ are present in data-set $S_B$. In response to this result mobile phone 20 sends a reply to computer 10 via the communication channel 30 indicating that data synchronization has been completed and that no further action is required. If however, the mobile phone 20 determines that some hashes are missing, then requires computer 1 to send the encoded packets.

This procedure is explained in connection with the rank reduction procedure.

## 5. Reduction of computational complexity by using Rank Reduction

It is assumed that data-set $S_B$ comprises the elements 3 and 5 and data-set $S_A$ includes the elements 2, 3 and 4. Moreover, encoder 11 has already encoded data-set $S_A$ into the four packets: Packet 1 [0 0 1 || 4], Packet 2 [0 1 0 || 3], Packet 3 [0 0 1 || 2] and Packet 4 [1 1 1 || 9] as described in section 3. These packets are stored in packet repository 13 of computer 10. Furthermore, mobile phone 20 has already received a hash packet containing the hashes h(2), h(3), and h(4). Now, by computing the hash of its own set elements $h(3)$ and $h(5)$, and comparing these hashes with the hashes of the hash packet, the mobile phone 20 can learn that the set element '3' is common to data-sets $S_A$ and $S_B$ and that the elements {2, 4} are missing in data-set $S_B$.

It is further assumed, that mobile phone 20 has requested computer 1 to send the encoded packets and that three encoded packets, for example the packets 1, 3 and 4 have been received by the mobile phone 20 since packet 2 has been lost during transmission (see section 4, ii.). However, only two packets are sufficient to decode the two missing elements. The mobile phone 20 can obtain the Beta matrix and the column vector $V_Y$ from the three packets as follows:

$$\beta = \begin{bmatrix} 0 & 0 & 1 \\ 1 & 0 & 0 \\ 1 & 1 & 1 \end{bmatrix}, V_Y = \begin{bmatrix} 4 \\ 2 \\ 9 \end{bmatrix}$$

Since element '3', corresponding to second column of the Beta matrix, generated at the computer 10 for the encoding step, is already available in data-set $S_B$ on mobile phone 10, it can be substracted from the column vector $V_Y$ and the second column of the Beta matrix can be deleted. As a result the new vector $V_Y$' and the new Beta matrix $\beta$' are as follows:

$$V'_Y = \begin{bmatrix} 4-0\times3 \\ 2-0\times3 \\ 9-1\times3 \end{bmatrix} = \begin{bmatrix} 4 \\ 2 \\ 6 \end{bmatrix}$$

and Beta is

$$\beta' = \begin{bmatrix} 0 & 1 \\ 1 & 0 \\ 1 & 1 \end{bmatrix}$$

We term this procedure "rank reduction". After the rank reduction, however, there remain only 2 unknowns to determine and three rows in the Beta matrix. Therefore, as discussed earlier, any one of the three rows can be erased to obtain a reduced vector $V_Y$" and a reduced Beta matrix $\beta$"

$$\beta'' = \begin{bmatrix} 0 & 1 \\ 1 & 1 \end{bmatrix} \quad \text{and} \quad V''_Y = \begin{bmatrix} 4 \\ 6 \end{bmatrix}$$

As a result, only the inverse of the reduced beta matrix $\beta''$ is computed at the decoder 24 as follows:

$$(\beta'')^{-1} = \begin{bmatrix} -1 & 1 \\ 1 & 0 \end{bmatrix}$$

Finally, the decoder 24 performs the last decoding step i.e. the matrix multiplication of

$$V''_A = (\beta'')^{-1} \times V''_Y = \begin{bmatrix} -1 & 1 \\ 1 & 0 \end{bmatrix} \times \begin{bmatrix} 4 \\ 6 \end{bmatrix} = \begin{bmatrix} 2 \\ 4 \end{bmatrix}$$

to obtain exactly the elements 2 and 4 of data-set $S_A$ that are missing in data-set $S_B$.
With the rank reduction, i.e. the strategy only to decode the elements which are missing in the data-set $S_B$ the computational complexity at the decoder 24 can be reduced.

**6. Reduction of computational complexity by using tree data structures**

The issue of reduction of communication and computational complexity is dealt with next using a tree data structure on computer 10 and mobile phone 20 to implement a divide-and-solve technique. This technique allows for using large data-sets and the random linear coding technique.

**Tree data structure**

Now, a further example is considered. It is assumed that data-set $S_A$ stored on the computer 10 comprises m=6 elements, i.e. 0, 1, 6, 10, 14 and 15, whereas data-set $S_B$ stored on the mobile phone 20 comprises n=3 elements, namely 0, 1 and. 9. The small sizes of data-sets are only chosen to facilitate the illustration.

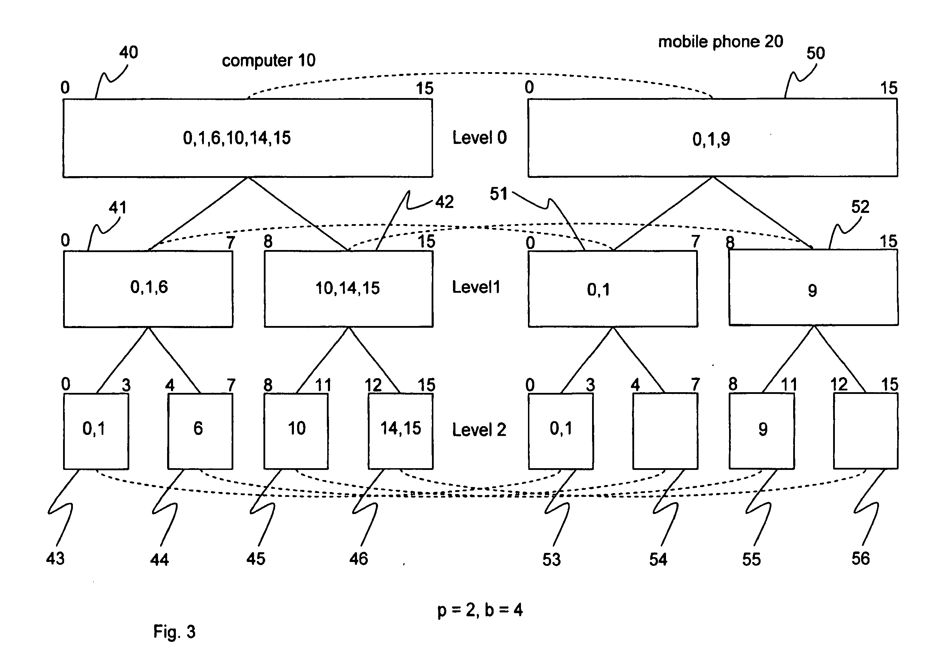

In general, computer 10 and mobile phone 20 may create a tree data-structure from the elements of data-set $S_A$ and from the data-set $S_B$, respectively. An example of a tree data structure is shown in Fig. 3, which depicts the tree data-structure utilized by the computer 10 as well as the tree data-structure utilized by the mobile phone 20. In the preferred embodiment the tree data-structure of data-set $S_A$ is stored on memory 17, wherein the tree data-structure of data-set $S_B$ is stored on memory 27. A tree is a multi-level hierarchical data structure composed of nodes, as depicted in Fig. 3. The node of the top level is called a root node, whereas the nodes of lower levels are called child nodes. The nodes belonging to the same level are set to the same predetermined field size. Each node contains the set elements that fit between the minimum and maximum field size of the respective node. The root node contains the entire data-set of the respective communication device because it spans the field that can accommodate the minimum and maximum valued element in the data-set. The root node also contains links to all its child nodes in the tree. An example of data-synchronization using a tree data-structure is explained now.

**Division into smaller data-subsets**

The division of the data-synchronization approach is implemented by dividing both data-set $S_A$ and data-set $S_B$ into disjoint data-subsets as illustrated in Fig. 3. The tree structure on the left side is located on the computer 10 whereas the tree structure on the right side is stored on the mobile phone 20. It should be noted, that a data-subset can be considered as the content of the respective child node, whereas the data-set itself can be considered as the content of a root node. In this embodiment the field size of the root node is set to $2^4 = 16$. All elements of both data-sets $S_A$ = {0, 1, 6, 10, 14, 15} and $S_B$ = {1, 9, 15} lie between 0 and 15. Furthermore, it is assumed that an ordering of the data-set elements is possible. In case of numerical data, this ordering can be based on the value whereas in case of string or textual data elements this ordering can be on a lexicographical basis. In the embodiment shown in Fig. 3 the numerical ordering is used to distribute the data-set elements to child nodes.

We define that the root node lies in level 0. Each root node 40 and 50 having a field size of 16 possible data-set elements 0, 1, 2, ..., 15 is then divided into two level-1 child nodes 41, 42 and 51, 52, respectively, wherein each level-1 child node has a field size of 8 possible data elements. Starting from the left to the right side, level-1 child node 41 may include the possible data elements 0 to 7, wherein level-1 child node 42 may include the possible data elements 8 to 15. In this case child node 41 stores the data elements 10, 1, 6} of data-set $S_A$, and child node 42 stores the elements {10, 14, 15} of data-set $S_A$. In a similar way level-1 child node 51 comprises the data elements {0, 1} and level-1 child node 52 comprises the element {9} of data-set $S_B$. Next, each level-1 child node is in turn divided into two level-2 child nodes of level 2, wherein each level-2 child node has a field size of 4 elements. Therefore, all 16 possible data-set elements can be distributed to the respective child nodes as shown in Fig. 3, starting again on the left side of the tree structure. In particular, level-1 child node 41 is divided into level-2 child nodes 43, 44, level-1 child node 42 is divided into level-2 child nodes 45, 46, level-1 child node 51 is divided into level-2 child nodes 53, 54 and level-1 child node 52 is divided into level-2 child nodes 55, 56. The elements of the respective level-2 data-subsets of data-set $S_A$ are distributed to the level-2 child nodes 43 to 46 as shown in Fig. 3. The elements of the respective level-2 data-subsets of data-set $S_B$ are distributed to the level-2 child nodes 53 to 56 as shown in Fig. 3, wherein child nodes 54 and 56 represents empty data-subsets. As can be seen the repeated division results in fewer elements in each child node according to the increasing number of levels. It should be noted that each node from 40 to 46 of the tree data structure on the computer 10 is logically linked to a corresponding node of the tree data-structure on the mobile phone 20, wherein the linked nodes lie on the same level. In particular, root node 40 is associated with root node 50, child node 41 is associated with child node 51, child node 42 is associated with child node 52 and so on as illustrated in Fig. 3 by the dashed lines. The tree data structures shown in Fig. 3 may be stored in memory 17 and 27, respectively, wherein each node may represent the respective memory location space. As a result the elements of each data-subset belonging to data-set $S_A$ can be stored at addressable locations of memory 17, whereas the elements of each data-subset belonging to data-set $S_B$ can be stored at addressable locations of memory 27.

It should be noted that the tree data-structures are created such that identical elements of data-set $S_A$ and data-set $S_B$ lie in the same nodes of the respective tree data structure. The dividing procedure may be repeated until the field size of the corresponding child nodes is small enough, for example less than or equal to the parameter k. The number of divisions of the field size is called the partition size p of the tree and corresponds to the maximum number of levels created. In the embodiment shown in Fig. 3 the partition size p is 2. The division procedure as described above can be called a set partitioning.

With performing a set partitioning as described above, the encoding and decoding process become much less computationally expensive since corresponding data-subsets of the data-sets $S_A$ and $S_B$ are processed subsequently instead of the complete data-sets. Therefore, a smaller beta matrix can be used for encoding and decoding the respective data-subsets. Although the number of nodes increases, the benefits due to solving several small synchronization problems and then merging the results exceed the benefits of a single large synchronization. The corresponding subsets on computer 10 and the mobile phone 20 are synchronized using the basic synchronization procedure described above. The results of several small synchronizations are combined in order to obtain the full synchronization of the data-sets $S_A$ and $S_B$.

**Encoding Procedure applied to a tree data structure**

The aim of the encoding procedure implemented at the encoder 11 is to create k encoded packets for each node of the tree that can be transmitted to the decoder 24 for subsequent decoding. The value of k is a tunable parameter of the system. A high value of k increases the size of the Beta matrix to invert using the matrix inversion process and hence this increases computation complexity. On the other hand a very low value of k will increase the number of feedback messages between the computer 10 and the mobile phone 20 as the mobile phone 20 needs to synchronize more tree nodes before the full synchronization is completed. Therefore, k should be relatively large, e.g. 64, if the decoding device is computationally capable, e.g. a personal computer and should be smaller if the decoding device is less capable, as for example mobile phone 20.

The basic encoding procedure as explained in section 2 is executed by the encoder 11 for each node 40 to 46 of the tree data-structure stored on the memory 17 and the resulting k encoded packets for each data-subset are stored, for example, at addressable locations of memory 12 for subsequent synchronization with the mobile phone 20. The encoding procedure for each node, i.e. each data-subset, is preferably executed a priori to the data synchronization in order to speed up the synchronization process by reducing the waiting time of the computations described below. Since the same encoded packets stored on memory 12 can be reused in multiple synchronizations with multiple decoding devices, this encoding cost is amortized over all the synchronization procedures.

In particular, a $k \times l_i$-Beta matrix is created for each child node 41 to 46 by a random number generator of computer 10, where k is 2, $l_i$ is the number of elements of child node i and i runs from 41 to 46. In particular, $1_{41}$ is 3, $l_{42}$ is 3 and so on. In a similar way, a $k \times m$-Beta matrix is created for root node 40, where m is 6. Next, the elements of each node which are represented by a column vector $V_A$ are multiplied, at the encoder 11, with the respective Beta matrix to obtain a k-element column vector $V_Y$ for each node. The rows of each Beta matrix and the elements of each vector $V_Y$ are stored on addressable locations of memory 12 such that they can be encapsulated in packets of a structure as shown in Fig. 2.

**Decoding procedure applied to a tree data structure**

The decoding procedure at the decoder 24 of the mobile phone 20 uses the tree data structure as shown on the right side of Fig. 3. The decoding process serves to retrieve the elements of data-set $S_A$ which are not included in data-set $S_B$. The decoder 24 starts with root node 50 and executes the decoding procedure as described in section 3. It should be noted that the same decoding procedure is applicable, if necessary, to each child node in the tree data structure.

The choice of whether to continue decoding a child node or not is determined in the following manner. If the rank of the Beta matrix, which is defined by the parameter k, is lesser than the number of different elements between two corresponding nodes then the leftmost child node of the next lower level is activated and the decoding procedure as described in section 3 is repeated for each child node from left to right. Therefore, by following this recursive procedure the data synchronization problem is subdivided into smaller synchronization tasks.

To illustrate this recursive data synchronization procedure, we consider the following example:

We return to Fig. 3 and assume that the number m of elements of data-set $S_A$ is 6, the number n of elements of data-set $S_B$ is 3, the partition size p is 2, the parameter k is 2 and the maximum size of the root node is 16 (b=4).

Therefore, regarding level 0 of the tree shown in Fig. 3 the minimum, maximum field is 0,15 respectively, wherein the minimum and maximum field elements are marked on the top left and top right of each tree node.

First, the procedure described in section 5 can be executed.

Thus, decoder 24 checks if root node 50, i.e. data-set $S_B$, has less than or equal to k=2 elements. If this is the case then the mobile phone 20 simply sends a request via the communication channel 30 to computer 10 to send all elements of root node 40, which correspond to the elements of data-set $S_A$. After receiving the data-set $S_A$ from computer 10 the mobile phone 20 determines the difference $S_A$-$S_B$.

In the present example, the decoder 24 determines that the root node 50 contains more than k=2 elements. Therefore, the mobile phone 20 requests computer 20 to send the hash packet containing the hashes for all 6 elements, that is h(0), h(1), h(6), h(10), h(14), h(16). Since the mobile phone 20 knows the hashes of all elements of its data-set $S_B$, that is h(0), h(1) and h(9) it determines that the size of the difference $S_A$-$S_B$ is 4, i.e. the total number of elements not included in data-set $S_B$ is 4. Therefore, the decoder 24 cannot decode the 4 elements since the encoder 11 of computer 10 only sends 2 encoded packets.

As a result, the mobile phone 20 invokes level 1 and child node 51 containing the elements {0, 1} of data-set $S_B$. Moreover, mobile phone 20 informs computer 10 that it uses now child node 51. In response to that information computer 10 knows that it has to use the corresponding child node 41. Therefore, computer 10 sends the hashes of all the elements included in child node 41, i.e. the hashes h(0), h(1), and h(6). It should be noted, that the elements {0, 1 and 6} correspond to the elements of the respective data-subset. Since mobile phone 20 knows the hashes of the elements {0, 1} included in child node 51 it determines that the difference is only of 1 element. Now, mobile phone 20 requests computer 10 to send the k=2 encoded packets belonging to child node 41. Therefore, if one or both encoded packets are successfully received by the mobile phone 20, the missing set element {6} can be decoded by the decoder 24 as described in section 3. Now, mobile phone 20 reduces the total number of differences to 3, which indicates that still 3 elements are missed in data-set $S_B$. Since the number of different elements is still greater than k=2 the mobile phone 20 invokes the next level-1 child node 52 containing element {9}). Mobile phone 20 requests computer 10 to use the corresponding child node 42. As a result, computer 10 sends the hashes of the elements {10, 14, 15}, which are contained in child node 42, to the mobile phone 20. In response to the received hashes and to the hash of element {9} of child node 52 the mobile phone 20 determines that the number of differences is still 3 and thus greater than 2. Therefore, the decoder 24 is unable to decode the 3 missing elements. Next, mobile phone 20 jumps from child node 52 to level 2 and chooses the left most level-2 child node 55 which depends on child node 52. Child node 55 contains element {9}. Now, mobile phone 20 requests computer 10 to select the corresponding child node 45 containing element {10}. Computer 10 transmits the hash of element 10 to the mobile phone 20 which recognizes that the difference is only 1 element between the child node 45 and child node 55. Therefore, mobile phone 20 requests computer 10 to send the two encoded packets representing child node 45. If at least one encoded packet is received by mobile phone 20 then decoder 24 can decode the missing element {10} as described above and the data synchronization between child node 45 and child node 55 is successful. In a similar way, mobile phone 20 finally invokes child node 56 and detects that the difference between the elements of child node 56 and the elements of the corresponding child node 46 on computer 10 is 2. Therefore, mobile phone 20 requests computer 10 to send the two encoded packets stored in memory 12 with respect to child node 46. If both encoded packets are received the decoder 24 can decode the last missing elements {14, 15} using the decoding procedure described above. Finally, decoder 24 combines the results of all data synchronization procedures executed subsequently which yields the complete difference $S_A$-$S_B$. In dependence on an implemented application, the missing elements {6, 10, 14 and 15} decoded by decoder 24 can be added to data-set $S_B$ and element {9} can be deleted. As a result data-set $S_A$ has been completely reconstructed on mobile phone 20.

It should be noted that the procedure of rank reduction as described in section 5 can be executed by the decoder 24 during each data-subset synchronization.

**7. Performance Data**

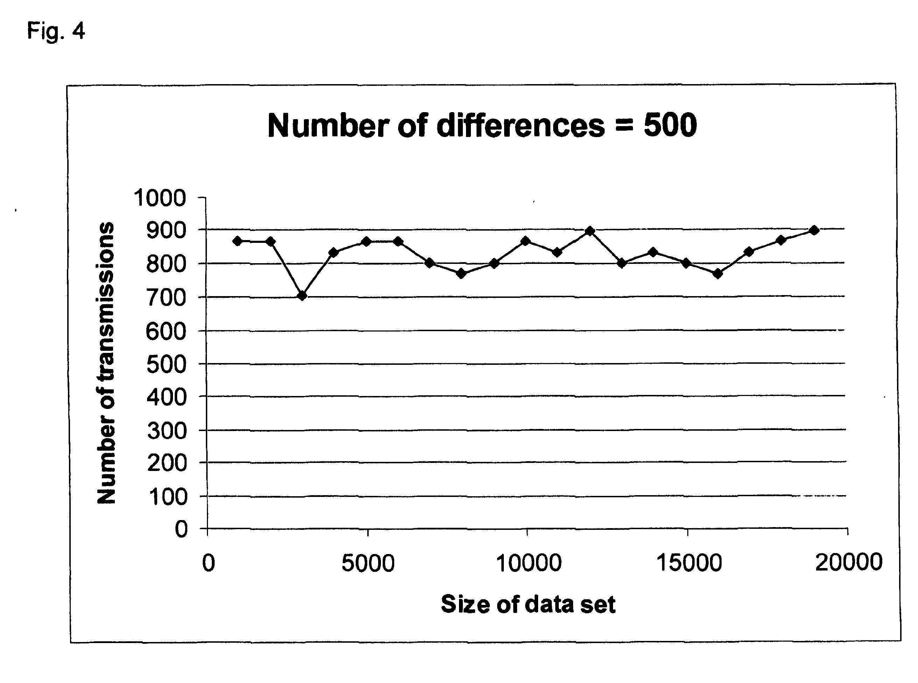

In this section, some performances with respect to an exemplary implementation of the system 1 are provided. The system 1 is efficient in communication because the number of transmitted packets from an encoding device such as computer 10 to a decoding device such as mobile phone 20 is independent of the size of the data-sets and only depends on the differences between the two data-sets $S_A$ and $S_B$. This behaviour is illustrated in Fig. 4 where the number of differences between the two data-sets $S_A$ and $S_B$ is kept constant at 500 different elements and the number of data-set elements is increased from 0 to 20000 (X axis). In this test run the set elements are chosen at random from a 32 bit field, k is set to 32, and the number of partitions is set to 4. The total number of encoded packets (Y axis) transmitted from the encoding device to the decoding device remains approximately constant even with increasing set size. This shows the inherent scalability of the system1 as compared to copying the whole data-set from the encoding device to the decoding device when the data-sets become big.

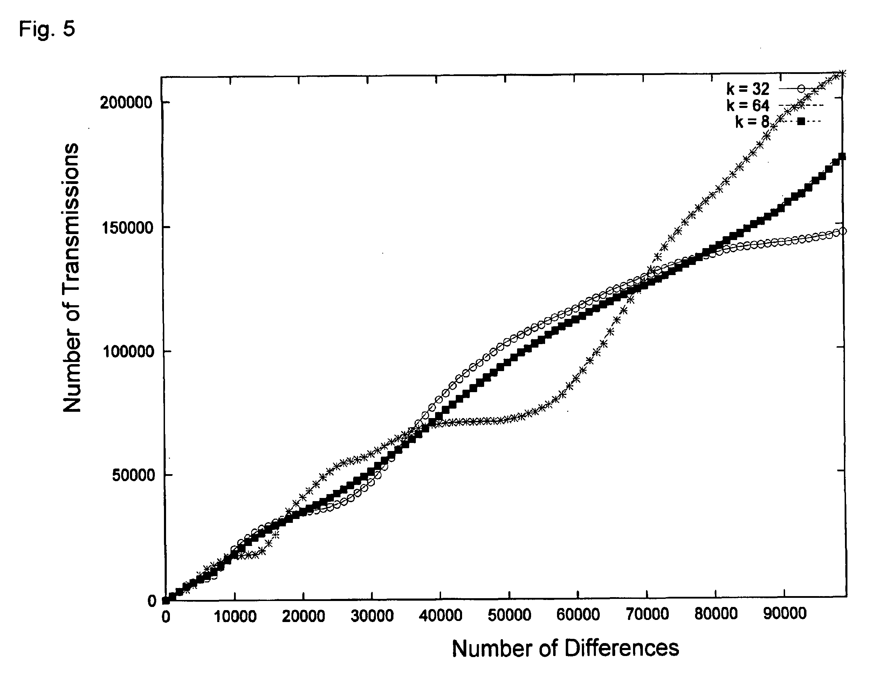

In the next experiment, the data-set size is fixed at 100000 elements and the number of differences between the data-set $S_A$ and $S_B$ (X axis) is increased. Fig. 5 shows the number of transmissions (Y axis) for increasing number of differences. The values of k used in this experiment were 8, 32, and 64 and the number of partitions was set to 4.

Fig. 5 shows that the number of packet transmissions grows linearly with the number of differences between the data-sets.

The described method and system results in an efficient and scalable data synchronization between two communication devices 10 and 20. The computer 10 encodes its data-set and sends this encoded data to the mobile phone 20. Mobile phone 20 then decodes this information in order to extract the data-set elements of the compute 10 that it is missing locally. In order to avoid large computational complexity when using random linear codes a novel speed-up process is used to reduce the number of computations via limited intelligent communication feedback from the mobile phone 20 to the computer 10 during the data synchronization process. As compared to ordinary well-known random linear codes, the use of intelligent feedback results in lowering the computational decoding complexity at the decoding side, thereby allowing the usage of the random linear code for much larger data-sets and/or enabling the deployment of the system on low computational power devices such as micro-sensors and mobile phones.

The system dynamically adapts to different synchronization scenarios as required by the application. Moreover, it can successfully synchronize data in scenarios where there are none, a few, many, or all identical data elements between the data-sets being synchronized.

In the preferred embodiment as described, data-set $S_B$ can be efficiently reconstructed on the mobile phone taking advantage of a bi-directional communication link 30. The system is successful in limiting the communication to within a constant multiple of the number of differences between data-sets $S_A$ and $S_B$ This means that irrespective of the number of elements in data-set $S_A$, the number of bytes transferred between computer 10 and mobile phone 20 is proportional to the number of differences between data-sets $S_A$ and $S_B$ and not proportional to the total number of set elements in the data-sets. Moreover, system 1 adapts to errors in data transmission by using error correction techniques between the communication devices during data synchronization and thereby reduces the chances of synchronization failure when the data-set $S_A$ is not identical to data-set $S_B$ at the end of the synchronization procedure.

## Claims

1. A method for synchronizing data-sets stored on different communication devices (10, 20) which are connected via communication links, comprising the steps of:

   1a) Storing a first data-set on a first communication device (10), said first data-set including a number of m elements;
   1b) Storing a second data-set on a second communication device (20), said second data-set including a number of n elements;
   1c) Encoding, at the first communication device (10), the first data-set by using a random linear code to obtain a number of k encoded elements, wherein k is a tunable parameter;
   1d) Determining, at the second communication device (20), the total number of elements, which are different between said first and second data-set, on the basis of a message received from the first communication device (10);
   1e) Determining, at the second communication device (20), whether the total number of different elements is less than or equal to the parameter k;
   1f) If yes, then transmitting the k encoded elements from the first communication device (10) to the second communication device (20);
   1g) Decoding, at the second communication device (20), at least some of the received encoded elements by using a random linear decoder in order to obtain all elements of the first data-set, which are not contained in the second data-set;
   2a) Performing a set partitioning on the first data-set in order to obtain a hierarchical, multilevel tree which comprises a plurality of first data-subsets;
   2b) Performing a set partitioning on the second data-set in order to obtain a hierarchical, multilevel tree which comprises a plurality of second data-subsets, wherein each of the first data-subsets corresponds to a separate one of the second data-subsets;
   2c) Encoding, at the first communication device (10), each first data-subset by using a random linear code in order to obtain a number of k encoded elements;
   2d) If the number of different elements determined in step 1d) is greater than k, then selecting, at the second communication device (20), a second data-subsets of the second data-set and selecting, at the first communication device (10), the corresponding first data-subset in response to a message received from the second communication device;
   2e) Determining, at the second communication device (20), the number of elements, which are different between the selected second data-subset and the corresponding first data-subset on the basis of a message received from the first communication device (10);

2f) Determining, at the second communication device (20), whether the number of different elements between the selected second data-subset and the selected first data-subset is less than or equal to the parameter k;

2g) If yes, then transmitting the k encoded elements of the first selected data-subset from the first communication device (10) to the second communication device (20); and

2h) Decoding, at the second communication device (20), at least some of the received encoded elements by using a random linear decoder in order to obtain the elements of the selected first data-subset, which are not contained in the selected second data-subset of the second data-set;

2i) Repeating steps 2d) to 2h) until all elements of the first data-set, which were initially not contained in the second data-set, have been decoded at the second communication device (20).

2. The method of claim 1, wherein
step 1c) comprises the further step of creating a k x m-Beta random number matrix (Beta), wherein said m elements of the first data-set are represented by an m-element column vector ($V_A$) and said k encoded elements are represented by a k-element column vector ($V_Y$), which is computed by performing the matrix multiplication of the Beta random number matrix and the m-element column vector; wherein prior to performing step 1f) each of the k encoded elements is encapsulated along with the entries of the respective row of the Beta random number matrix into a separate packet to be transmitted; and wherein step 1g) comprises the step of computing the inverse of said received Beta random number matrix, wherein the m-element column vector is computed by performing the matrix multiplication of the inverse of said Beta random number matrix and the k-element column vector.

3. The method of claim 1, wherein
step 2c) comprises the further step of creating with respect to each first data-subset a k x $l_i$-Beta random number matrix, where $l_i$ corresponds to the number of elements of the ith first data-subset and $l_i$ is less than m, wherein said $l_i$ elements of the ith first data-subset are represented by an $l_i$-element column vector and said k encoded elements are represented by a k-element column vector, which is computed by performing the matrix multiplication of the Beta random number matrix and the $l_i$-element column vector; wherein prior to performing step 2g) each of the k encoded elements is encapsulated along with the entries of the respective row of the Beta random number matrix into a separate packet to be transmitted; and wherein
step 2h) comprises the step of computing the inverse of the received k x $l_i$-Beta random number matrix, wherein the $l_i$-element column vector is computed by performing the matrix multiplication of the inverse of said Beta random number matrix and the k-element column vector.

4. The method of any one of the preceding claims,
wherein prior to performing the decoding step 1g) the common elements between the first data-set and the second data-set are determined and wherein only the received encoded elements which are not included in the second data-set are decoded, and/or wherein prior to performing the decoding step 2h) the common elements between the selected second data-subset and the corresponding first data-subset are determined and wherein only the received encoded elements which are not included in the selected data-subset of the second data-set are decoded.

5. The method of any one of the preceding claims, wherein step 2d) comprises the following steps:

- transmitting a request from the second communication device to the first communication device for sending a message concerning all elements included in the first data-set;
- transmitting the message in a single packet to the second communication device, and

wherein step 2e) comprises the following steps:

- transmitting a request from the second communication device to the first communication device for sending a message concerning all elements included in the selected first data-subset;
- transmitting the respective information in a single packet to the second communication device.

6. The method of claim 5,
wherein the information comprises the hashes of each element included in the first data-set and/or the hashes of each element of the selected first data-subset, wherein
step 1d) comprises the further steps of:

generating, at the second communication device, the hash of each element included in the second data-set;
comparing the hashes of each element included in the first data-set received from the first communication device to the hashes of the elements of the second data-set in order to determine the total number of elements of the first data-set which are not included in the second data-set; and wherein
step 2e) comprises the further steps of:

generating, at the second communication device, the hash of each element included in the selected second data-subset;
comparing the hashes of each element of the selected first data-subset received from the first communication device with the hashes of the elements of the selected second data-subset in order to determine the number of elements of the selected first data-subset which are not included in the selected second data-subset.

7. The method of any one of the preceding claims, wherein step 2g) comprises the step of requesting the first communication device for sending the k encoded elements.

8. The method of any one of the preceding claims, comprising the following steps of:

determining, at the second communication device, whether the number of elements of the second data-set or the number of elements of a selected second data-sub-set is less than or equal to the parameter k;
if yes, requesting the first communication device for transmitting all elements of the first data-set or for transmitting all elements of the selected first data-subset, which corresponds to the selected second data-subset, to the second communication device.

9. A distributed computing system (1) for synchronizing data-sets stored on different communication devices which are connected via communication links, comprising

a) a first communication device (10) which comprises the following features:

- first storage means (18) for storing a first data-set, said first data-set including a number of m elements,
- an encoder (11) for encoding the first data-set by using a random linear code to obtain a number of k encoded elements, wherein k is a tunable parameter,
- a transmitter (13) for transmitting the k encoded elements to the second communication device in response to a request of the second communication device;
- means for performing a set partitioning on the first data-set in order to obtain a hierarchical, multilevel tree which comprises a plurality of first data-subsets,
- means for selecting a first data-subset in response to a message received from the second communication device,
- wherein the encoder (11) is adapted to encode each first data-subset by using a random linear code in order to obtain a number of k encoded elements, and

b) a second communication device (20) connected via a communication link (30) with the first communication device (10), said second communication device (20) comprising the following features:

- first storing means (28) for storing a second data-set, said second data-set including a number of n elements;
- means (26) for determining the total number of elements, which are different between said first and second data-set, on the basis of a message received from the first communication device (10) and for determining, whether the total number of different elements is less than or equal to the parameter k,
- a decoder (24) for decoding, if the number of different elements is less than or equal to k, the k received encoded elements by using a random linear decoder in order to obtain all elements of the first data-set, which are not contained in the second data-set,
- means for performing a set partitioning on the second data-set in order to obtain a hierarchical, multilevel tree which comprises a plurality of second data-subsets, wherein each first data-subset corresponds to a separate second data-subset of the second data-set,
- means for selecting, if the number of different elements is greater than k, at least one second data-subset according to a predetermined rule,
- means for determining the number of elements, which are different between the selected second data-subset and the selected first data-subset on the basis of a message received from the first communication device (10) whereby the first selected data-subset and the selected second data-subset correspond to each other and for determining whether the number of different elements is less than or equal to the parameter k,
- wherein the decoder (24) is adapted to decode, if the number of different elements between said selected second data-subset and said selected first data-subset is less than or equal to k, at least some of the k received encoded elements of the first selected data-subset by using a random linear decoder in order to obtain the elements of the first data-subset, which are not contained in the selected second data-subset of the second data-set.

10. The distributed computing system of claim 9, wherein the first communication device (10) comprises second storage means (12) for storing the encoded elements.

11. The distributed computing system of any one of the claims 8 to 9, wherein
the encoder (11) is adapted to use a k x m-Beta random number matrix to encode the first data-set, wherein the first communication device comprises means for encapsulating each of the k encoded elements along with the entries of the respective row of the Beta random number matrix into a separate packet, and wherein the decoder (24) is adapted to compute the inverse of the received Beta random number matrix.

12. The distributed computing system of any one of the claims 9 to 11,

- wherein the encoder (11) is adapted to use, for each first data-subset to be encoded, a k x $l_i$-Beta random number matrix, where li corresponds to the number of elements of the ith first data-subset and $l_i$ is less than m,
- wherein the first communication device comprises means for encapsulating each of the k encoded elements of a respective first data-subset along with the entries of the respective row of the k x $l_i$- Beta random number matrix into a separate packet, and
- wherein the decoder (24) is adapted to compute the inverse of the received k x $l_i$-Beta random number matrix.

**Patentansprüche**

1. Verfahren zum Synchronisieren von Datenmengen, die in unterschiedlichen, über Kommunikationsverbindungen miteinander verbunden Kommunikationseinrichtungen (10, 20) gespeichert sind, mit folgenden Schritten:

1a) Speichern einer ersten Datenmenge in einer ersten Kommunikationseinrichtung (10), wobei die erste Datenmenge eine Anzahl m von Elementen umfasst;
1b) Speichern einer zweiten Datenmenge in einer zweiten Kommunikationseinrichtung (20), wobei die zweite Datenmenge eine Anzahl n von Elementen umfasst;
1c) Kodieren der ersten Datenmenge in der ersten Kommunikationseinrichtung (10) unter Verwendung eines linearen Zufallscodes, um eine Anzahl k von kodierten Elementen zu erhalten, wobei k ein anpassbarer Parameter ist;
1d) Bestimmen der Gesamtanzahl von zwischen der ersten und der zweiten Datenmenge unterschiedlichen Elementen in der zweiten Kommunikationseinrichtung (20) auf Basis einer von der ersten Kommunikationseinrichtung (10) empfangenen Nachricht;
1e) Bestimmen, in der zweiten Kommunikationseinrichtung (20), ob die Gesamtanzahl unterschiedlicher Elemente kleiner oder gleich dem Parameter k ist;
1f) falls ja, Übertragen der k kodierten Elemente von der ersten Kommunikationseinrichtung (10) zu der zweiten Kommunikationseinrichtung (20);
1g) Dekodieren, in der zweiten Kommunikationseinrichtung (20), zumindest eines Teils der empfangenen kodierten Elemente unter Verwendung eines linearen Zufallsdekodierers, um sämtliche Elemente der ersten Datenmenge zu erhalten, die nicht in der zweiten Datenmenge enthalten sind;
2a) Durchführen einer Datenmenge-Unterteilung auf die erste Datenmenge, um eine hierarchische Mehrebenen-Baumstruktur zu erhalten, die eine Mehrzahl von ersten Datenteilmengen umfasst;
2b) Durchführen einer Datenmenge-Unterteilung auf die zweite Datenmenge, um eine hierarchische Mehrebenen-Baumstruktur zu erhalten, die eine Mehrzahl von zweiten Datenteilmengen umfasst, wobei jede der ersten Datenteilmengen einer separaten der zweiten Datenteilmengen entspricht;
2c) Kodieren jeder ersten Datenteilmenge in der ersten Kommunikationseinrichtung (10) unter Verwendung eines linearen Zufallscodes, um eine Anzahl k von kodierten Elementen zu erhalten;
2d) falls die Anzahl der in Schritt 1d) bestimmten unterschiedlichen Elemente größer als k ist, Auswählen einer zweiten Datenteilmenge der zweiten Datenmenge an der zweiten Kommunikationseinrichtung (20), und Auswählen der entsprechenden ersten Datenteilmenge in der ersten Kommunikationseinrichtung (10) unter Ansprechen auf eine von der zweiten Kommunikationseinrichtung empfangenen Nachricht;
2e) Bestimmen der Anzahl von zwischen der ausgewählten zweiten Datenteilmenge und der entsprechenden ersten Datenteilmenge unterschiedlichen Elementen in der zweiten Kommunikationseinrichtung (20) auf Basis einer von der ersten Kommunikationseinrichtung (10) empfangenen Nachricht;

2f) Bestimmen, in der zweiten Kommunikationseinrichtung (20), ob die Anzahl unterschiedlicher Elemente zwischen der ausgewählten zweiten Datenteilmenge und der ausgewählten ersten Datenteilmenge kleiner oder gleich dem Parameter k ist;

2g) falls ja, Übertragen der k kodierten Elemente der ersten ausgewählten Datenteilmenge von der ersten Kommunikationseinrichtung (10) zu der zweiten Kommunikationseinrichtung (20); und

2h) Dekodieren, in der zweiten Kommunikationseinrichtung (20), zumindest eines Teils der empfangenen kodierten Elemente unter Verwendung eines linearen Zufallsdekodierers, um die Elemente der ausgewählten ersten Datenteilmenge zu erhalten, die nicht in der ausgewählten zweiten Datenteilmenge des zweiten Datensatzes enthalten sind;

2i) Wiederholen der Schritte 2d) bis 2h), bis sämtliche Elemente der ersten Datenmenge, die anfangs nicht in der zweiten Datenmenge enthalten waren, an der zweiten Kommunikationseinrichtung (20) dekodiert worden sind.

2. Verfahren nach Anspruch 1, wobei

Schritt 1c) den weiteren Schritt umfasst,

eine k x m Beta-Zufallszahlenmatrix (Beta) zu erzeugen, wobei die m Elemente der ersten Datenmenge durch einen Spaltenvektor ($V_A$) mit m Elementen dargestellt werden und wobei die k kodierten Elemente durch einen Spaltenvektor ($V_Y$) mit k Elementen dargestellt werden, der durch Ausführen einer Matrixmultiplikation der Beta-Zufallszahlenmatrix mit dem Spaltenvektor mit m Elementen berechnet wird; wobei vor Ausführung des Schrittes 1f) jedes der k kodierten Elemente zusammen mit den Einträgen der jeweiligen Zeile der Beta-Zufallszahlenmatrix in einem separaten zu übertragenden Paket eingekapselt wird; und wobei

Schritt 1g) den Schritt umfasst, die Inverse der empfangenen Beta-Zufallszahlenmatrix zu berechnen, wobei der Spaltenvektor mit m Elementen durch Ausführen einer Matrixmultiplikation der Inversen der Beta-Zufallszahlenmatrix mit dem Spaltenvektor mit k Elementen berechnet wird.

3. Verfahren nach Anspruch 1, wobei

Schritt 2c) den weiteren Schritt umfasst, in Bezug auf jede erste Datenteilmenge eine k x $l_i$ Beta-Zufallszahlenmatrix zu erzeugen, wobei $l_i$ der Anzahl von Elementen in der i-ten ersten Datenteilmenge entspricht und $l_i$ kleiner als m ist, wobei die $l_i$ Elemente der i-ten ersten Datenteilmenge durch einen Spaltenvektor mit $l_i$ Elementen dargestellt werden und die k kodierten Elemente durch einen Spaltenvektor mit k Elementen dargestellt werden, der durch Ausführen einer Matrixmultiplikation der Beta-Zufallszahlenmatrix mit dem Spaltenvektor mit $l_i$ Elementen berechnet wird;

wobei vor Ausführung des Schrittes 2g) jedes der k kodierten Elemente zusammen mit den Einträgen der jeweiligen Zeile der Beta-Zufallszahlenmatrix in einem separaten zu übertragenden Paket eingekapselt wird; und wobei

Schritt 2h) den Schritt umfasst, die Inverse der empfangenen k x $l_i$ Beta-Zufallszahlenmatrix zu berechnen, wobei der Spaltenvektor mit $l_i$ Elementen durch Ausführen einer Matrixmultiplikation der Inversen der Beta-Zufallszahlenmatrix mit dem Spaltenvektor mit k Elementen berechnet wird.

4. Verfahren nach einem der vorhergehenden Ansprüche, wobei vor dem Ausführen des Dekodierschrittes 1g) die gemeinsamen Elemente zwischen der ersten Datenmenge und der zweiten Datenmenge bestimmt werden, und wobei nur diejenigen der empfangenen kodierten Elemente, die nicht in der zweiten Datenmenge enthalten sind, dekodiert werden, und/oder wobei vor dem Ausführen des Dekodierschrittes 2h) die gemeinsamen Elemente zwischen der ausgewählten zweiten Datenteilmenge und der entsprechenden ersten Datenteilmenge bestimmt werden, und wobei nur diejenigen der empfangenen kodierten Elemente, die nicht in der ausgewählten Datenteilmenge der zweiten Datenmenge enthalten sind, dekodiert werden.

5. Verfahren nach einem der vorhergehenden Ansprüche, wobei Schritt 2d) die folgenden Schritte umfasst:

- Übertragen einer Aufforderung von der zweiten Kommunikationseinrichtung an die erste Kommunikationseinrichtung zum Senden einer Nachricht, die sämtliche in der ersten Datenmenge enthaltenen Elemente betrifft;
- Übertragen der Nachricht in einem einzigen Paket an die zweite Kommunikationseinrichtung; und

wobei Schritt 2e) die folgenden Schritte umfasst:

- Übertragen einer Aufforderung von der zweiten Kommunikationseinrichtung an die erste Kommunikationseinrichtung zum Senden einer Nachricht, die sämtliche in der ausgewählten ersten Datenteilmenge enthaltenen Elemente betrifft;
- Übertragen der jeweiligen Informationen in einem einzigen Paket an die zweite Kommunikationseinrichtung.

6. Verfahren nach Anspruch 5,
wobei die Informationen die Hashwerte von jedem in der ersten Datenmenge enthaltenen Element und/oder die Hashwerte von jedem Element der ausgewählten ersten Datenteilmenge umfassen, wobei
Schritt 1d) die folgenden weiteren Schritte umfasst:

Erzeugen des Hashwertes für jedes in der zweiten Datenmenge enthaltene Element an der zweiten Kommunikationseinrichtung;
Vergleichen der von der ersten Kommunikationseinrichtung empfangenen Hashwerte jedes in der ersten Datenmenge enthaltenen Elements mit den Hashwerten der Elemente der zweiten Datenmenge, um die Gesamtanzahl der Elemente der ersten Datenmenge zu bestimmen, die nicht in der zweiten Datenmenge enthalten sind; und wobei
Schritt 2e) die folgenden weiteren Schritte umfasst:

Erzeugen des Hashwertes für jedes in der ausgewählten zweiten Datenteilmenge enthaltene Element an der zweiten Kommunikationseinrichtung,
Vergleichen der von der ersten Kommunikationseinrichtung empfangenen Hashwerte für jedes Element der ausgewählten ersten Datenteilmenge mit den Hashwerten der Elemente der ausgewählten zweiten Datenteilmenge, um die Anzahl der Elemente der ausgewählten ersten Datenteilmenge zu bestimmen, die nicht in der ausgewählten zweiten Datenteilmenge enthalten sind.

7. Verfahren nach einem der vorhergehenden Ansprüche, wobei Schritt 2g) den Schritt umfasst, die erste Kommunikationseinrichtung zum Senden der k kodierten Elemente aufzufordern.

8. Verfahren nach einem der vorhergehenden Ansprüche, wobei dieses folgende Schritte umfasst:

Bestimmen, in der zweiten Kommunikationseinrichtung, ob die Anzahl der Elemente der zweiten Datenmenge oder die Anzahl der Elemente einer ausgewählten zweiten Datenteilmenge kleiner oder gleich dem Parameter k ist;
falls ja, Auffordern der ersten Kommunikationseinrichtung, alle Elemente der ersten Datenmenge oder alle Elemente der ausgewählten ersten Datenteilmenge, die der ausgewählten zweiten Datenteilmenge entsprechen, an die zweite Kommunikationseinrichtung zu übertragen.

9. Verteiltes Computersystem (1) zum Synchronisieren von Datenmengen, die in unterschiedlichen Kommunikationseinrichtungen gespeichert sind, die über Kommunikationsverbindungen miteinander verbunden sind, umfassend:

a) eine erste Kommunikationseinrichtung (10), die folgende Merkmale aufweist:

- eine erste Speichereinrichtung (18) zum Speichern einer ersten Datenmenge, wobei die erste Datenmenge eine Anzahl m von Elementen umfasst,
- einen Kodierer (11) zum Kodieren der ersten Datenmenge unter Verwendung eines linearen Zufallscodes, um eine Anzahl k von kodierten Elementen zu erhalten, wobei k ein anpassbarer Parameter ist,
- einen Sender (13) zum Übertragen der k kodierten Elemente an die zweite Kommunikationseinrichtung in Ansprechen auf eine Anforderung von der zweiten Kommunikationseinrichtung;
- Einrichtungen zum Ausführen einer Datenmenge-Unterteilung auf die erste Datenmenge, um eine hierarchische Mehrebenen-Baumstruktur zu erhalten, die eine Mehrzahl von ersten Datenteilmengen umfasst;
- Einrichtungen zum Auswählen einer ersten Datenteilmenge unter Ansprechen auf eine von der zweiten Kommunikationseinrichtung empfangene Nachricht;
- wobei der Kodierer (11) dazu angepasst ist, jede erste Datenteilmenge unter Verwendung eines linearen Zufallscodes zu kodieren, um eine Anzahl k von kodierten Elementen zu erhalten; und

b) eine zweite Kommunikationseinrichtung (20), die über eine Kommunikationsverbindung (30) mit der ersten Kommunikationseinrichtung (10) verbunden ist, wobei die zweite Kommunikationseinrichtung (20) die folgenden Merkmale aufweist:

- eine erste Speichereinrichtung (28) zum Speichern einer zweiten Datenmenge, wobei die zweite Datenmenge eine Anzahl n von Elementen umfasst;
- Einrichtungen (26) zum Bestimmen der Gesamtanzahl von zwischen der ersten und der zweiten Datenmenge unterschiedlichen Elementen auf Basis einer von der ersten Kommunikationseinrichtung (10) empfangenen Nachricht, und zum Bestimmen, ob die Gesamtanzahl unterschiedlicher Elemente kleiner oder gleich dem Parameter k ist;
- einen Dekodierer (24) zum Dekodieren der k empfangenen kodierten Elemente, wenn die Anzahl unterschiedlicher Elemente kleiner oder gleich k ist, unter Verwendung eines linearen Zufallsdekodierers, um sämtliche Elemente der ersten Datenmenge zu erhalten, die nicht in der zweiten Datenmenge enthalten sind;
- Einrichtungen zum Ausführen einer Datenmengen-Unterteilung auf die zweite Datenmenge, um eine hierarchische Mehrebenen-Baumstruktur zu erhalten, die eine Mehrzahl von zweiten Datenteilmengen umfasst, wobei jede erste Datenteilmenge einer separaten zweiten Datenteilmenge entspricht;
- Einrichtungen zum Auswählen mindestens einer zweiten Datenteilmenge entsprechend einer vorgegebenen Regel, wenn die Anzahl der unterschiedlichen Elemente größer als k ist,
- Einrichtungen zum Bestimmen der Anzahl von zwischen der ausgewählten zweiten Datenteilmenge und der ausgewählten ersten Datenteilmenge unterschiedlichen Elementen auf Basis einer von der ersten Kommunikationseinrichtung (10) empfangenen Nachricht, wobei die erste ausgewählte Datenteilmenge und die ausgewählte zweite Datenteilmenge einander entsprechen, und zum Bestimmen, ob die Anzahl unterschiedlicher Elemente kleiner oder gleich dem Parameter k ist;
- wobei der Dekodierer (24) dazu angepasst ist, zumindest einen Teil der k empfangenen, kodierten Elemente der ersten ausgewählten Datenteilmenge unter Verwendung eines linearen Zufallsdekodierers zu dekodieren, wenn die Anzahl unterschiedlicher Elemente zwischen der ausgewählten zweiten Datenteilmenge und der ausgewählten ersten Datenteilmenge kleiner oder gleich k ist, um die Elemente der ausgewählten ersten Datenteilmenge zu erhalten, die nicht in der ausgewählten zweiten Datenteilmenge der zweiten Datenmenge enthalten sind.

**10.** Verteiltes Computersystem nach Anspruch 9, wobei die erste Kommunikationseinrichtung (10) eine zweite Speichereinrichtung (12) zum Speichern der kodierten Elemente umfasst.

**11.** Verteiltes Computersystem nach einem der Ansprüche 8 bis 9, wobei
der Kodierer (11) dazu angepasst ist, eine k x m Beta-Zufallszahlenmatrix zu verwenden, um den ersten Datensatz zu kodieren, wobei die erste Kommunikationseinrichtung Einrichtungen zum Verkapseln jedes der k kodierten Elemente zusammen mit den Einträgen der jeweiligen Zeile der Beta-Zufallszahlenmatrix in einem separaten Paket umfasst, und wobei der Dekodierer (24) dazu angepasst ist, die Inverse der empfangenen Beta-Zufallszahlenmatrix zu berechnen.

**12.** Verteiltes Computersystem nach einem der Ansprüche 9 bis 11,

- wobei der Kodierer (11) dazu angepasst ist, für jede zu kodierende erste Datenteilmenge eine k x $l_i$ Beta-Zufallszahlenmatrix zu verwenden, wobei $l_i$ der Anzahl von Elementen in der i-ten ersten Datenteilmenge entspricht und $l_i$ kleiner als m ist,
- wobei die erste Kommunikationseinrichtung Einrichtungen zum Einkapseln jedes der k kodierten Elemente einer jeweiligen ersten Datenteilmenge zusammen mit den Einträgen der jeweiligen Zeile der k x $l_i$ Beta-Zufallszahlenmatrix in einem separaten Paket umfasst, und
- wobei der Dekodierer (24) dazu angepasst ist, die Inverse der empfangenen k x $l_i$ Beta-Zufallszahlenmatrix zu berechnen.

## Revendications

**1.** Procédé pour synchroniser des ensembles de données mémorisés sur différents dispositifs de communication (10, 20) qui sont connectés par l'intermédiaire de liaisons de communication, comprenant les étapes :

1a) de mémorisation d'un premier ensemble de données sur un premier dispositif de communication (10), ledit premier ensemble de données comprenant un nombre m d'éléments ;
1b) de mémorisation d'un deuxième ensemble de données sur un deuxième dispositif de communication (20), ledit deuxième ensemble de données comprenant un nombre n d'éléments ;
1c) d'encodage, au niveau du premier dispositif de communication (10), du premier ensemble de données en utilisant un code linéaire aléatoire pour obtenir un nombre k d'éléments encodés, où k est un paramètre accordable ;

1d) de détermination, au niveau du deuxième dispositif de communication (20), du nombre total d'éléments, qui diffèrent entre lesdits premier et deuxième ensembles de données, sur la base d'un message reçu du premier dispositif de communication (10) ;

1e) de détermination, au niveau du deuxième dispositif de communication (20), si le nombre total d'éléments différents est inférieur ou égal au paramètre k ;

1f) si c'est le cas, alors de transmission des k éléments encodés du premier dispositif de communication (10) au deuxième dispositif de communication (20) ;

1g) de décodage, au niveau du deuxième dispositif de communication (20), d'au moins certains des éléments encodés reçus en utilisant un décodeur linéaire aléatoire afin d'obtenir tous les éléments du premier ensemble de données, qui ne sont pas contenus dans le deuxième ensemble de données ;

2a) d'exécution d'une partition d'ensemble sur le premier ensemble de données afin d'obtenir une arborescence hiérarchique à multiples niveaux qui comprend une pluralité de premiers sous-ensembles de données ;

2b) d'exécution d'une partition d'ensemble sur le deuxième ensemble de données afin d'obtenir une arborescence hiérarchique à multiples niveaux qui comprend une pluralité de deuxièmes sous-ensembles de données, où chacun des premiers sous-ensembles de données correspond à un sous-ensemble séparé parmi les deuxièmes sous-ensembles de données ;

2c) d'encodage, au niveau du premier dispositif de communication (10), de chaque premier sous-ensemble de données en utilisant un code linéaire aléatoire afin d'obtenir un nombre k d'éléments encodés ;

2d) si le nombre d'éléments différents déterminé à l'étape 1d) est supérieur à k, alors de sélection, au niveau du deuxième dispositif de communication (20), d'un deuxième sous-ensemble de données du deuxième ensemble de données et de sélection, au niveau du premier dispositif de communication (10), du premier sous-ensemble de données correspondant en réponse à un message reçu du deuxième dispositif de communication ;

2e) de détermination, au niveau du deuxième dispositif de communication (20), du nombre d'éléments, qui diffèrent entre le deuxième sous-ensemble de données sélectionné et le premier sous-ensemble de données correspondant sur la base d'un message reçu du premier dispositif de communication (10) ;

2f) de détermination, au niveau du deuxième dispositif de communication (20), si le nombre d'éléments différents entre le deuxième sous-ensemble de données sélectionné et le premier sous-ensemble de données sélectionné est inférieur ou égal au paramètre k ;

2g) si c'est le cas, alors de transmission des k éléments encodés du premier sous-ensemble de données sélectionné du premier dispositif de communication (10) au deuxième dispositif de communication (20) ; et

2h) de décodage, au niveau du deuxième dispositif de communication (20), d'au moins certains des éléments encodés reçus en utilisant un décodeur linéaire aléatoire afin d'obtenir les éléments du premier sous-ensemble de données sélectionné, qui ne sont pas contenus dans le deuxième sous-ensemble de données sélectionné du deuxième ensemble de données ;

2i) de répétition des étapes 2d) à 2h) jusqu'à ce que tous les éléments du premier ensemble de données, qui n'étaient pas contenus initialement dans le deuxième ensemble de données, aient été décodés au niveau du deuxième dispositif de communication (20).

2. Procédé selon la revendication 1, dans lequel

l'étape 1c) comprend l'étape supplémentaire de création d'une matrice de k x m nombres aléatoires Beta (Beta), où lesdits m éléments du premier ensemble de données sont représentés par un vecteur de colonne de m éléments ($V_A$) et lesdits k éléments encodés sont représentés par un vecteur de colonne de k éléments ($V_Y$), qui est calculé en effectuant la multiplication matricielle de la matrice de nombres aléatoires Beta et du vecteur de colonne de m éléments ; dans lequel, avant d'effectuer l'étape 1f), chacun des k éléments encodés est encapsulé avec les entrées de la rangée respective de la matrice de nombres aléatoires Beta dans un paquet séparé à transmettre ; et dans lequel l'étape 1g) comprend l'étape de calcul de l'inverse de ladite matrice de nombres aléatoires Beta reçue, dans lequel le vecteur de colonne de m éléments est calculé en effectuant la multiplication matricielle de l'inverse de ladite matrice de nombres aléatoires Beta et du vecteur de colonne de k éléments.

3. Procédé selon la revendication 1, dans lequel

l'étape 2c) comprend l'étape supplémentaire de création, en relation avec chaque premier sous-ensemble de données, d'une matrice de $k \times l_i$ nombres aléatoires Beta, dans lequel $l_i$ correspond au nombre d'éléments du $i^{\text{ème}}$ premier sous-ensemble de données et $l_i$ est inférieur à m, où lesdits $l_i$ éléments du $i^{\text{ème}}$ premier sous-ensemble de données sont représentés par un vecteur de colonne de $l_i$ éléments et lesdits k éléments encodés sont représentés par un vecteur de colonne de k éléments, qui est calculé en effectuant la multiplication matricielle de la matrice de nombres aléatoires Beta et du vecteur de colonne de $l_i$ éléments ; dans lequel, avant l'exécution de l'étape 2g), chacun des k éléments encodés est encapsulé avec les entrées de la rangée respective de la matrice de nombres aléatoires Beta dans un paquet séparé à transmettre ; et dans lequel

l'étape 2h) comprend l'étape de calcul de l'inverse de la matrice de $k \times l_i$ nombres aléatoires Beta reçue, où le vecteur de colonne de $l_i$ éléments est calculé en effectuant la multiplication matricielle de l'inverse de ladite matrice de nombres aléatoires Beta et du vecteur de colonne de k éléments.

4. Procédé selon l'une quelconque des revendications précédentes,
dans lequel, avant l'exécution de l'étape de décodage 1g), les éléments communs entre le premier ensemble de données et le deuxième ensemble de données sont déterminés et dans lequel seuls les éléments encodés reçus qui ne sont pas inclus dans le deuxième ensemble de données sont décodés, et/ou dans lequel, avant l'exécution de l'étape de décodage 2h), les éléments communs entre le deuxième sous-ensemble de données sélectionné et le premier sous-ensemble de données correspondant sont déterminés et dans lequel seuls les éléments encodés reçus qui ne sont pas inclus dans le sous-ensemble de données sélectionné du deuxième ensemble de données sont décodés.

5. Procédé selon l'une quelconque des revendications précédentes,
dans lequel l'étape 2d) comprend les étapes suivantes :

- de transmission d'une demande du deuxième dispositif de communication au premier dispositif de communication pour envoyer un message concernant tous les éléments inclus dans le premier ensemble de données ;
- de transmission du message dans un paquet unique au deuxième dispositif de communication, et

dans lequel l'étape 2e) comprend les étapes suivantes :

- de transmission d'une demande du deuxième dispositif de communication au premier dispositif de communication pour envoyer un message concernant tous les éléments inclus dans le premier sous-ensemble de données sélectionné ;
- de transmission des informations respectives dans un paquet unique au deuxième dispositif de communication.

6. Procédé selon la revendication 5,
dans lequel les informations comprennent les hachages de chaque élément inclus dans le premier ensemble de données et/ou les hachages de chaque élément du premier sous-ensemble de données sélectionné, dans lequel l'étape 1d) comprend les étapes supplémentaire :

de génération, au niveau du deuxième dispositif de communication, du hachage de chaque élément inclus dans le deuxième ensemble de données ;
de comparaison des hachages de chaque élément inclus dans le premier ensemble de données reçu du premier dispositif de communication aux hachages des éléments du deuxième ensemble de données afin de déterminer le nombre total d'éléments du premier ensemble de données qui ne sont pas inclus dans le deuxième ensemble de données ; et dans lequel
l'étape 2e) comprend les étapes supplémentaire :

de génération, au niveau du deuxième dispositif de communication, du hachage de chaque élément inclus dans le deuxième sous-ensemble de données sélectionné ;
de comparaison des hachages de chaque élément du premier sous-ensemble de données sélectionné reçu du premier dispositif de communication avec les hachages des éléments du deuxième sous-ensemble de données sélectionné afin de déterminer le nombre d'éléments du premier sous-ensemble de données sélectionné qui ne sont pas inclus dans le deuxième sous-ensemble de données sélectionné.

7. Procédé selon l'une quelconque des revendications précédentes, dans lequel l'étape 2g) comprend l'étape de demande au premier dispositif de communication d'envoyer les k éléments encodés.

8. Procédé selon l'une quelconque des revendications précédentes, comprenant les étapes suivantes :

de détermination, au niveau du deuxième dispositif de communication, si le nombre d'éléments du deuxième ensemble de données ou le nombre d'éléments d'un deuxième sous-ensemble de données sélectionné est inférieur ou égal au paramètre k ;
si c'est le cas, de demande au premier dispositif de communication de transmettre tous les éléments du premier ensemble de données ou de transmettre tous les éléments du premier sous-ensemble de données sélectionné, qui correspond au deuxième sous-ensemble de données sélectionné, au deuxième dispositif de communication.

9. Système informatique réparti (1) pour synchroniser des ensembles de données mémorisés sur différents dispositifs de communication qui sont connectés par l'intermédiaire de liaisons de communication, comprenant :

a) un premier dispositif de communication (10) qui comprend les caractéristiques suivantes :

- des premiers moyens de mémorisation (18) pour mémoriser un premier ensemble de données, ledit premier ensemble de données comprenant un nombre m d'éléments,
- un encodeur (11) pour encoder le premier ensemble de données en utilisant un code linéaire aléatoire pour obtenir un nombre k d'éléments encodés, où k est un paramètre accordable,
- un émetteur (13) pour transmettre les k éléments encodés au deuxième dispositif de communication en réponse à une demande du deuxième dispositif de communication ;
- des moyens pour exécuter une partition d'ensemble sur le premier ensemble de données afin d'obtenir une arborescence hiérarchique à multiples niveaux qui comprend une pluralité de premiers sous-ensembles de données,
- des moyens pour sélectionner un premier sous-ensemble de données en réponse à un message reçu du deuxième dispositif de communication,
- dans lequel l'encodeur (11) est conçu pour encoder chaque premier sous-ensemble de données en utilisant un code linéaire aléatoire afin d'obtenir un nombre k d'éléments encodés, et

b) un deuxième dispositif de communication (20) connecté par l'intermédiaire d'une liaison de communication (30) au premier dispositif de communication (10), ledit deuxième dispositif de communication (20) comprenant les caractéristiques suivantes :

- des premiers moyens de mémorisation (28) pour mémoriser un deuxième ensemble de données, ledit deuxième ensemble de données comprenant un nombre n d'éléments ;
- des moyens (26) pour déterminer le nombre total d'éléments, qui diffèrent entre lesdits premier et deuxième ensembles de données, sur la base d'un message reçu du premier dispositif de communication (10) et pour déterminer si le nombre total d'éléments différents est inférieur ou égal au paramètre k,
- un décodeur (24) pour décoder, si le nombre d'éléments différents est inférieur ou égal à k, les k éléments encodés reçus en utilisant un décodeur linéaire aléatoire afin d'obtenir tous les éléments du premier ensemble de données, qui ne sont pas contenus dans le deuxième ensemble de données,
- des moyens pour effectuer une partition d'ensemble sur le deuxième ensemble de données afin d'obtenir une arborescence hiérarchique à multiples niveaux qui comprend une pluralité de deuxièmes sous-ensembles de données, où chaque premier sous-ensemble de données correspond à un deuxième sous-ensemble de données séparé du deuxième ensemble de données,
- des moyens pour sélectionner, si le nombre d'éléments différents est supérieur à k, au moins un deuxième sous-ensemble de données conformément à une règle prédéterminée,
- des moyens pour déterminer le nombre d'éléments, qui diffèrent entre le deuxième sous-ensemble de données sélectionné et le premier sous-ensemble de données sélectionné sur la base d'un message reçu du premier dispositif de communication (10), moyennant quoi le premier sous-ensemble de données sélectionné et le deuxième sous-ensemble de données sélectionné correspondent l'un à l'autre, et pour déterminer si le nombre d'éléments différents est inférieur ou égal au paramètre k,
- dans lequel le décodeur (24) est conçu pour décoder, si le nombre d'éléments différents entre ledit deuxième sous-ensemble de données sélectionné et ledit premier sous-ensemble de données sélectionné est inférieur ou égal à k, au moins certains des k éléments encodés reçus du premier sous-ensemble de données sélectionné en utilisant un décodeur linéaire aléatoire afin d'obtenir les éléments du premier sous-ensemble de données, qui ne sont pas contenus dans le deuxième sous-ensemble de données sélectionné du deuxième ensemble de données.

10. Système informatique réparti selon la revendication 9, dans lequel le premier dispositif de communication (10) comprend des deuxièmes moyens de mémorisation (12) pour mémoriser les éléments encodés.

11. Système informatique réparti selon l'une quelconque des revendications 8 à 9, dans lequel l'encodeur (11) est conçu pour utiliser une matrice de k x m nombres aléatoires Beta pour encoder le premier ensemble de données, dans lequel le premier dispositif de communication comprend des moyens pour encapsuler chacun des k éléments encodés avec les entrées de la rangée respective de la matrice de nombres aléatoires Beta dans un paquet séparé, et dans lequel le décodeur (24) est conçu pour calculer l'inverse de la matrice de nombres aléatoires Beta reçue.

12. Système informatique réparti selon l'une quelconque des revendications 9 à 11,

- dans lequel l'encodeur (11) est conçu pour utiliser, pour chaque premier sous-ensemble de données à encoder, une matrice de $k \times l_i$ nombres aléatoires Beta, où $l_i$ correspond au nombre d'éléments du $i^{ème}$ premier sous-ensemble de données et $l_i$ est inférieur à m,
- dans lequel le premier dispositif de communication comprend des moyens pour encapsuler chacun des k éléments encodés d'un premier sous-ensemble de données respectif avec les entrées de la rangée respective de la matrice de $k \times l_i$ nombres aléatoires Beta dans un paquet séparé, et
- dans lequel le décodeur (24) est conçu pour calculer l'inverse de la matrice de $k \times l_i$ nombres aléatoires Beta reçue.

Fig. 1

| Packet 1 | $\beta_{11}$ | $\beta_{12}$ | $\beta_{13}$ | . . . | $\beta_{1m}$ | $y_1$ |

| Packet 2 | $\beta_{21}$ | $\beta_{22}$ | $\beta_{23}$ | . . . | $\beta_{2m}$ | $y_2$ |

| Packet 3 | $\beta_{31}$ | $\beta_{32}$ | $\beta_{33}$ | . . . | $\beta_{3m}$ | $y_3$ |

| Packet k | $\beta_{k1}$ | $\beta_{k2}$ | $\beta_{k3}$ | . . . | $\beta_{km}$ | $y_k$ |

Metadata                    Payload

Fig. 2

computer 10     mobile phone 20

Fig. 3

$p = 2, b = 4$

Fig. 4

Number of differences = 500

EP 2 434 413 B1

Fig. 5

Number of Transmissions

Number of Differences

k = 32
k = 64
k = 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. AGARWAL et al.** Near optimal update-broadcast of data sets. *PROCEEDINGS, IEEE 8TH INTERNATIONAL CONFERENCE ON MOBILE DATA MANAGEMENT,* 27 January 2007, 356-360

- **D. STAROBINSKI et al.** Efficient PDA Synchronization. *IEEE TRANSACTIONS ON MOBILE COMPUTING,* 01 January 2003, vol. 2 (1), 40-51